# EUROPEAN PATENT APPLICATION

(11) **EP 4 751 834 A1**
(43) Date of publication of application: **03.06.2026**
(21) Application number: 25219124.2
(22) Date of filing: 27.11.2025
(51) Int. Cl.: B23K 9/073, B23K 9/09, B23K 9/095, B23K 9/173

(54) **SYSTEMS AND METHODS FOR DETECTION OF SHORT CIRCUIT EVENTS BY DETECTING ANOMALOUS CATHODE EVENTS**

(30) Priority: 27.11.2024 US 202463725895 P; 26.11.2025 US 202519401960
(71) Applicant: Illinois Tool Works Inc., Glenview IL 60025 (US)
(72) Inventor: WAGNER, Dustin Carter, Glenview, 60025 (US); UECKER, James Lee, Glenview, 60025 (US)
(74) Representative: HGF

(57) **Abstract**

A welding system comprises: power conversion circuitry configured to output welding power to a weld circuit; a voltage sensor configured to measure a voltage of the weld circuit; and control circuitry configured to: control the power conversion circuitry to output the welding power according to one or more first welding parameters; monitor the measured voltage during a background phase to determine whether a short circuit event occurred in the weld circuit by detecting that the measured voltage is greater than an anomalous cathode event voltage threshold; in response to determining that the short circuit event occurred, determine one or more second welding parameters based on one or more short circuit parameters of the short circuit event; and control the power conversion circuitry to output the welding power according to one or more second welding parameters.

## Description

### RELATED APPLICATIONS

The present application claims the benefit of U.S. Provisional Patent Application Serial No. 63/725,895, filed November 27, 2024, entitled "SYSTEMS AND METHODS FOR DETECTION OF SHORT CIRCUIT EVENTS BY DETECTING ANOMALOUS CATHODE EVENTS." The entirety of U.S. Provisional Patent Application Serial No. 63/725,895 is expressly incorporated herein by reference.

### FIELD OF THE DISCLOSURE

This disclosure relates generally to welding systems and, more particularly, to systems and methods for detection of short circuit events by detecting anomalous cathode events.

### BACKGROUND

Welding components (e.g., welding torches) are sometimes powered by welding power supplies. Conventional power supplies use a range of electrical components and/or electrical circuitry to produce appropriate welding power for various welding operations and/or welding components.

Power supplies may be used to conduct a welding operation, such as an arc welding operation. For example, gas-metal arc welding ("GMAW") (also referred to as metal inert gas welding ("MIG")) is a welding process in which an electric arc forms between an electrode and pieces of metal that are to be welded. In many systems, the electrode consists of a wire that is advanced through a welding torch. The power source applies electrical current to the electrode so as to pass the electric arc between the electrode and a work piece, thereby heating the electrode and causing the pieces of metal to melt. Upon cooling down of the melted pieces of metal, the pieces of metal join and form a weld. Electrical and/or physical parameters can be adjusted to give the best electric arc possible and improve the overall welding process.

### SUMMARY

Systems and methods for detection of short circuit events by detecting anomalous cathode events are disclosed, substantially as illustrated by and described in connection with at least one of the figures, as set forth more completely in the claims.

### BRIEF DESCRIPTION OF THE DRAWINGS

FIG. 1 illustrates an example welding system configured to detect short circuit events by detecting anomalous cathode events, in accordance with aspects of this disclosure;
FIG. 2 illustrates a graph (x-axis: time; y-axis: voltage) of measured voltages of a welding system during two example pulse cycles, in accordance with aspects of this disclosure;
FIGS. 3A-3D illustrate an example sequence of maintaining an arc length by adjusting one or more welding parameters, in accordance with aspects of this disclosure;
FIG. 4A illustrates a graph (x-axis: time; y-axis: voltage) of measured voltages of a welding system during a first example pulse cycle including a detected anomalous cathode event and a second example pulse cycle including a detected short circuit event, in accordance with aspects of this disclosure;
FIG. 4B illustrates a graph (x-axis: time; y-axis: voltage) of measured voltages of a welding system during a third example pulse cycle including a detected short circuit event and a fourth example pulse cycle including a detected short circuit event and a detected anomalous cathode event, in accordance with aspects of this disclosure; and
FIG. 5 illustrates a flowchart representative of example machine readable instructions which may be executed by the welding system of FIG. 1 to control welding parameters during a welding operation, in accordance with aspects of this disclosure.

The figures are not necessarily to scale. Where appropriate, similar or identical reference numbers are used to refer to similar or identical components.

### DETAILED DESCRIPTION

Inexperienced welders, while welding, often struggle to maintain often-desirable aspects of a weld process, such as a constant arc length, travel speed, weld angle, contact tip to work distance ("CTWD"), etc. Failure to maintain appropriate weld technique may decrease the quality of welds they produce and/or increase the time necessary to conduct a welding operation (e.g., by requiring repetition of a welding process). A welding arc that has an arc length which is too long or too short may increase spatter, reduce weld quality (e.g., by a short welding arc providing too little heat and reducing attachment strength of a weld, a long welding arc providing too much heat and burning a hole through a workpiece, etc.), and/or warp, distort, and/or otherwise damage a workpiece.

Some disclosed example systems, methods, and control circuitry provide improved control and/or maintenance of an arc length of a welding arc by determining one or more welding parameters based on one or more short circuit parameters of one or more short circuit events. Some disclosed examples employ a pulsed welding process (e.g., GMAW-P) that utilizes "pulses" (e.g., a controlled increase of voltage, current, power, enthalpy, resistance, etc. of weld power for a defined period of time). For example, a pulsed welding process may employ one or more "pulse cycles." A pulse cycle may alternate between one or more higher-voltage "peak" phases (e.g., pulses) and one or more other phases (e.g., a lower-voltage "background" phase). In some examples, the pulsed welding process is configured to cause a short circuit event after each pulse. In other cases, short circuit events may be unintentional or inadvertent.

In an example pulse cycle, a pulse creates a molten ball at a tip of an electrode (e.g., welding wire) of the welding system and deposits the molten ball of material onto a workpiece. For example, a higher voltage of a peak phase of a pulse cycle may melt a greater amount of the electrode than a lower voltage of a background phase of the pulse cycle. The molten ball may be deposited to a weld pool on the workpiece, and the molten ball may briefly join the electrode to the weld pool in a short circuit event that decreases weld voltage (e.g., to a voltage level below a target voltage of a background phase). By measuring one or more parameters of a short circuit event, disclosed examples determine one or more aspects of a welding system and/or a welding operation, such as by determining an arc length of a welding arc based on a measured duration of a short circuit event (a "short circuit duration"). Accordingly, disclosed examples may control one or more aspects of a welding system and/or a welding operation by modifying one or more welding parameters based on one or more measured parameters of one or more short circuit events. In some examples, one or more other welding modes and/or transfer modes may be used.

A short circuit parameter may be used, e.g., to determine one or more parameters of a welding system and/or as a proxy for one or more parameters of a welding system. For example, a short circuit duration may indicate an arc length of a welding arc. A short circuit duration that is shorter than a target short circuit duration may indicate that the tip of the electrode of the welding system is too far from the work piece (e.g., because a molten ball may join an electrode and a weld pool for a shorter period of time when the electrode is further from the weld pool). Conversely, a short circuit duration that is longer than a target short circuit duration may indicate that the tip of the electrode of the welding system is too close to the work piece, e.g., because a molten ball may join an electrode and a weld pool for a longer period of time when the electrode is closer to the weld pool.

Accordingly, some disclosed examples receive a target short circuit parameter (e.g., a single value and/or a range of values) or determine the target short circuit parameter (e.g., based on a target arc length of a welding arc). A short circuit parameter may include a short circuit duration and/or one or more other measurable qualities of one or more short circuit events. Some disclosed examples compare one or more measured short circuit durations to the target short circuit duration to determine whether an arc length of the welding arc is equal to the target arc length value and/or within the target arc length range and, if not, modify one or more welding parameters (e.g., pulse width, pulse frequency, target peak voltage, target peak current, ramp up rate, wire feed speed, etc.) to adjust the arc length of the welding arc based on, e.g., the target arc length and the difference between the measured short circuit duration and the target short circuit duration. For example, modifying one or more welding parameters by, e.g., modifying a duration of a waveform phase, modifying a duration of a portion of a waveform, increasing a pulse width, increasing a waveform frequency, increasing a pulse frequency, increasing a target voltage, increasing a target current, increasing a ramp up rate, and/or decreasing a ramp down rate may cause an electrode to melt faster due to increased heat being applied to the electrode. By melting the electrode faster, a distance between a tip of the electrode and a weld pool (e.g., an "arc length) may increase by decreasing a length of an electrode extension of the electrode (e.g., a distance the electrode extends past a contact tip of a welding torch). Conversely, the electrode can be made to melt slower, e.g., by modifying a duration of a waveform phase, modifying a waveform frequency, otherwise modifying one or more portions of a waveform, decreasing a pulse width, decreasing a pulse frequency, decreasing a target voltage, decreasing a target current, decreasing a ramp up rate, and/or increasing a ramp down rate. Accordingly, one or more welding parameters may be automatically controlled based on measured short circuit duration to maintain and/or control an arc length of a welding arc.

By controlling and/or maintaining an arc length of a welding arc, disclosed example systems, methods, and control circuitry may lower the difficulty of welding, improve the quality of a weld, and/or reduce the time required for a welding operation by reducing or eliminating instances of undesirable arc lengths during the welding operation and, thereby, problems and disruptions caused by such undesirable arc lengths. A background phase may have a duration of, e.g., greater than or equal to 1 milliseconds and/or less than or equal to 25 milliseconds. A pulse phase may have a duration of, e.g., greater than or equal to 1 millisecond and less than or equal to 3 milliseconds, less than or equal to 5 milliseconds, and/or one or more other durations, depending on factors such as wire diameter. Accordingly, during some disclosed example pulse welding operations, 300 or more short circuit events may occur per second. Due to such high frequencies of short circuit events, using one or more measured parameters of such short circuit events for controlling one or more welding parameters of a welding system and/or a welding operation may enable very rapid adjustment of such welding parameters. Some disclosed examples may, thereby, automatically, quickly, and/or accurately determine and/or implement modifications to one or more welding parameters by comparing one or more measured short circuit parameters (e.g., a measured short circuit duration) with one or more target short circuit parameters (e.g., a target short circuit duration) to control one or more aspects of a welding system and/or a welding process (e.g., arc length of a welding arc).

Short circuit events may be detected by, e.g., detecting a measured voltage that is less than a short circuit detection voltage threshold (e.g., a low voltage amount). When controlling one or more welding parameters based on one or more measured short circuit durations, however, failure to detect a short circuit event can result in undesirable outcomes. For example, failure to detect a short circuit event may cause an erroneous determination that a short circuit event did not occur or an erroneous determination that a very brief short circuit occurred (e.g. when a short circuit is expected to occur but is not detected). As a result, modification (or lack thereof) of one or more welding parameters based on this erroneous determination can occur.

Failure to detect a short circuit event can occur when a short circuit duration of the short circuit event is very brief. For example, a short circuit event having a short circuit duration that is less than a magnitude of time between voltage measurements may result in voltage measurements which occur before and after, but not during, the short circuit event, and the timing of the brief short circuit event between such measurements may cause the voltage measurements to fail to indicate that the short occurred. Disclosed example systems, methods, and control circuitry may detect short circuit events via additional mechanisms and/or processes, such as by detecting one or more events which, if occurring, indicate that a short circuit event occurred or was likely to have occurred.

Some brief short circuit events may cause an anomalous cathode event. The term "anomalous cathode event," as used herein, refers to a rapid increase in voltage (e.g., above a target background voltage) during a background phase. An anomalous cathode event may occur when metal vapor is trapped in plasma of a welding arc, and anomalous cathode events result in very high voltages which do not correlate with arc length of the welding arc. If an anomalous cathode event occurs (e.g., in a background phase of a pulse cycle), the event is generally preceded by a short circuit event. For example, the relatively rapid transfer of a molten ball from a tip of an electrode to a weld pool during a relatively brief short circuit event (when compared to relatively longer short circuit events) can cause a welding arc to change in, e.g., composition and/or shape similarly rapidly, and such changes can cause a measured voltage of a weld circuit to briefly increase. Accordingly, the detection of an anomalous cathode event (e.g., during a background phase of a pulse cycle) may be used as an indicator that a short circuit event has also occurred.

Accordingly, disclosed example systems, methods, and control circuitry detect short circuit events by detecting anomalous cathode events. By detecting that an anomalous cathode event occurred, disclosed examples can infer that a short circuit event also occurred. In some disclosed examples, if an anomalous cathode event is detected in the absence of detecting a short circuit event (e.g., after a pulse), then such disclosed examples may determine that a brief, undetected short circuit event occurred. Using this determination, some such disclosed examples may modify one or more welding parameters based on one more predetermined short circuit parameters (e.g., a predetermined short circuit duration), such as one or more predetermined short circuit parameters associated with detection of anomalous cathode events when no associated short circuit event is otherwise detected.

The term "arc length," as used herein, refers to the distance over which a welding-type arc extends between an end or tip of an electrode (e.g., welding wire) of a welding torch and a work piece (e.g., a piece, component, etc. being welded).

The term "electrode extension," as used herein, refers to a portion of an electrode (e.g., welding wire) extending beyond (e.g., outside of) a contact tip of a welding torch or other welding device.

As used herein, the terms "welding power" and "welding-type power" refer to power suitable for welding, plasma cutting, plasma welding, induction heating, air carbon arc cutting ("CAC-A") and/or hot wire welding/preheating (including laser welding and laser cladding). As used herein, the term "welding-type power supply" refers to any device capable of, when power is applied thereto, supplying welding, plasma cutting, plasma welding, induction heating, CAC-A and/or hot wire welding/preheating (including laser welding and laser cladding) power, including but not limited to inverters, converters, resonant power supplies, quasi-resonant power supplies, and the like, as well as control circuitry and other ancillary circuitry associated therewith.

As used herein, the term "welding mode" refers to the type and/or modality of process and/or output used by a welding system, such as gas-metal arc welding ("GMAW") (also referred to as metal inert gas welding ("MIG")), pulsed gas-metal arc welding ("GMAW-P") (also referred to as "pulsed MIG"), current-controlled welding, voltage-controlled welding, power-controlled welding, resistance-controlled welding, enthalpy-controlled welding, pulse welding, tungsten inert gas ("TIG") (also referred to as gas tungsten arc welding ("GTAW")), flux cored arc welding ("FCAW"), shielded metal arc welding ("SMAW") (also referred to as "stick welding"), plasma cutting, plasma welding, spray welding, short circuit transfer welding, pulsed spray welding, and/or one or more other welding modes. As used herein, the term "transfer mode" refers to the mechanism by which an electrode is transferred to a workpiece (e.g., a weld pool on the work piece), and a welding mode may include one or more transfer modes. A transfer mode may include, e.g., short circuit welding, pulse welding, spray welding, pulsed spray welding, Regulated Metal Deposition (i.e., RMD ^{®}), and/or one or more other transfer modes.

As used herein, the term "welding parameter-controlled mode" (as in, e.g., a "voltage-controlled mode," a "current-controlled mode," a "power-controlled mode," a "resistance-controlled mode," an "enthalpy-controlled mode," etc.) refers to an operating mode of one or more components, systems, and/or processes of a welding operation (e.g., of power conversion circuitry, a generator, one or more other sources of welding power, a wire feeder, control circuitry, etc.) wherein one or more welding parameters are controlled and/or otherwise modified based on a difference between one or more measured welding parameters and one or more respective target welding parameters (e.g., one or more target values, one or more target threshold values, one or more target ranges of values, etc.). For example, when controlling power conversion circuitry to output welding power to a weld circuit in a voltage-controlled mode, control circuitry may control the power conversion circuitry to increase or decrease an output current (e.g., a number of amps) of the power conversion circuitry and/or one or more other welding parameters based on a difference between a measured voltage of the weld circuit and a target voltage.

As used herein, a "target" welding parameter (e.g., a "target voltage," a "target current," a "target power," a "target resistance," a "target enthalpy," etc.) refers to one or more inputs associated with a welding parameter according to which a welding system operating in a controlled mode (e.g., a voltage-controlled mode, a current-controlled mode, a power-controlled mode, an enthalpy-controlled mode, a resistance-controlled mode, etc.) controls and/or otherwise modifies one or more other welding parameters based on differences between a measured welding parameter and the target welding parameter. A target welding parameter may include one or more values (e.g., 24V), one or more value ranges (e.g., 23V-25V), one or more threshold values (e.g., ≥ 23V, < 25V), etc.

As used herein, a welding parameter "setpoint" (e.g., a voltage setpoint, a current setpoint, a power setpoint, a resistance setpoint, an enthalpy setpoint, a wire feed speed setpoint, etc.) refers to an input (e.g., one or more voltage values, one or more current values, one or more power values, one or more resistance values, one or more enthalpy values, one or more wire feed speed values, etc.) to a device and/or system of a welding system (e.g., a power converter, a wire feeder, a welding torch, a power source, etc.), e.g., via a user interface, network communication, weld procedure specification, or other selection method.

As used herein, the term "pulse cycle" refers to a group two or more phases according to which a welding operation is conducted, wherein one or more welding parameters are varied between at least two phases. For example, a pulse cycle may comprise a peak phase and a background phase, and a target peak voltage of the peak phase may be greater than a target background voltage of the background phase. A pulse cycle may include, e.g., one or more background phases, one or more peak phases, one or more wetting phases, one or more dabbing phases, one or more intermediate phases, and/or one or more other phases.

Disclosed example welding systems comprise: power conversion circuitry configured to convert input power to welding power and to output the welding power to a weld circuit; a voltage sensor configured to measure a voltage of the weld circuit and generate a voltage sensor signal comprising a measured voltage; and control circuitry configured to: control the power conversion circuitry to output the welding power according to one or more first pulse cycles having one or more first pulse parameters; monitor the voltage sensor signal during a background phase of the one or more first pulse cycles to determine whether a short circuit event occurred in the weld circuit by detecting that the measured voltage is greater than an anomalous cathode event voltage threshold; in response to determining that the short circuit event occurred, determine one or more second pulse parameters based on the one or more first pulse parameters and one or more short circuit parameters of the short circuit event; and control the power conversion circuitry to output the welding power according to one or more second pulse cycles having the one or more second pulse parameters.

In some example welding systems, the anomalous cathode event voltage threshold is greater than a target background voltage of the one or more first pulse parameters.

In some example welding systems, at least one of the one or more second pulse parameters are configured to maintain an arc length of a welding arc of the weld circuit based on the one or more short circuit parameters and on a target arc length.

In some example welding systems, the control circuitry is further configured to compare the one or more short circuit parameters to one or more target short circuit parameters to determine one or more short circuit parameter target differences; and the determining of the one or more second pulse parameters is based on the one or more first pulse parameters and the one or more short circuit parameter target differences. In some such example welding systems, the determining of the one or more second pulse parameters further comprises: in response to determining that a magnitude of at least one of the one or more short circuit parameter target differences is greater than a short circuit parameter target difference magnitude threshold, modifying at least one of the one or more first pulse parameters based on the magnitude of the at least one of the one or more short circuit parameter target differences; and in response to determining that the magnitude of at least one of the one or more short circuit parameter target differences is not greater than the short circuit parameter target difference magnitude threshold, maintaining the one or more first pulse parameters as the one or more second pulse parameters.

In some example welding systems, the one or more first pulse parameters comprise a first pulse width; and the one or more second pulse parameters comprise a second pulse width.

In some example welding systems, the one or more first pulse parameters comprise at least one of a first pulse width, a first pulse frequency, a first wire feed speed, a first ramp up rate, a first ramp down rate, a first target peak voltage, a first target peak current, a first target background voltage, a first target background current, a first target power, a first target resistance, or a first target enthalpy; and the one or more second pulse parameters comprise at least one of a second pulse width, a second pulse frequency, a second wire feed speed, a second ramp up rate, a second ramp down rate, a second target peak voltage, a second target peak current, a second target background voltage, a second target background current, a second target power, a second target resistance, or a second target enthalpy.

In some example welding systems, the one or more short circuit parameters comprise at least one of a measured short circuit duration, a predetermined short circuit duration, a measured short circuit voltage, a measured average short circuit voltage, a predetermined short circuit voltage, a measured short circuit current, a measured average short circuit current, or a predetermined short circuit current.

In some example welding systems, the control circuitry is further configured to, in response to determining that the short circuit event occurred by detecting that the measured voltage is greater than the anomalous cathode event voltage threshold during the background phase, associate the short circuit event with one or more predetermined short circuit parameters associated with an anomalous cathode event and determine the one or more second pulse parameters based on the one or more predetermined short circuit parameters. In some such example welding systems, the one or more predetermined short circuit parameters comprise a predetermined short circuit duration; the one or more first pulse parameters comprise a first pulse width; the one or more second pulse parameters comprise a second pulse width; and the control circuitry is further configured to, in response to determining that the predetermined short circuit duration is greater than a target short circuit duration, determine the second pulse width by increasing the first pulse width based on a difference between the predetermined short circuit duration and the target short circuit duration.

In some example welding systems, the control circuitry is further configured to, in response to determining that the short circuit event occurred by detecting that the measured voltage is greater than the anomalous cathode event voltage threshold during the background phase, associate the short circuit event with one or more predetermined short circuit parameters associated with an anomalous cathode event and determine the one or more second pulse parameters based on the one or more predetermined short circuit parameters, wherein: the one or more predetermined short circuit parameters comprise a predetermined short circuit duration; the one or more first pulse parameters comprise a first pulse width; the one or more second pulse parameters comprise a second pulse width; and the control circuitry is further configured to, in response to determining that the predetermined short circuit duration is less than a target short circuit duration, determine the second pulse width by decreasing the first pulse width based on a difference between the predetermined short circuit duration and the target short circuit duration. In some such example welding systems, the control circuitry is further configured to determine the predetermined short circuit duration based on a sampling rate of the voltage sensor.

In some example welding systems, the control circuitry is further configured to monitor the voltage sensor signal during the background phase to determine whether the short circuit event occurred in the weld circuit by detecting that the measured voltage is less than a short circuit detection voltage threshold. In some such example welding systems, the short circuit detection voltage threshold is less than a target background voltage of the one or more first pulse parameters.

In some example welding systems, the control circuitry is further configured to monitor the voltage sensor signal during the background phase to determine whether the short circuit event occurred in the weld circuit by detecting that the measured voltage is less than a short circuit detection voltage threshold; and the control circuitry is further configured to, in response to determining that the short circuit event occurred by detecting that the measured voltage is less than the short circuit detection voltage threshold during the background phase, associate the short circuit event with one or more measured short circuit parameters and determine the one or more second pulse parameters based on the one or more measured short circuit parameters. In some such example welding systems, the one or more measured short circuit parameters comprise a measured short circuit duration; the one or more first pulse parameters comprise a first pulse width; the one or more second pulse parameters comprise a second pulse width; and the control circuitry is further configured to: in response to determining that the measured short circuit duration is greater than a target short circuit duration, calculate the second pulse width by increasing the first pulse width based on a difference between the measured short circuit duration and the target short circuit duration; and in response to determining that the measured short circuit duration is less than the target short circuit duration, calculate the second pulse width by decreasing the first pulse width based on the difference between the measured short circuit duration and the target short circuit duration.

In some example welding systems, the control circuitry is further configured to monitor the voltage sensor signal during the background phase to determine whether the short circuit event occurred in the weld circuit by detecting that the measured voltage is less than a short circuit detection voltage threshold; the control circuitry is further configured to, in response to determining that the short circuit event occurred by detecting that the measured voltage is less than the short circuit detection voltage threshold during the background phase, associate the short circuit event with one or more measured short circuit parameters and determine the one or more second pulse parameters based on the one or more measured short circuit parameters; the one or more measured short circuit parameters comprise a measured short circuit duration; the one or more first pulse parameters comprise a first target peak voltage; the one or more second pulse parameters comprise a second target peak voltage; and the control circuitry is further configured to: in response to determining that the measured short circuit duration is greater than a target short circuit duration, calculate the second target peak voltage by increasing the first target peak voltage based on a difference between the measured short circuit duration and the target short circuit duration; and in response to determining that the measured short circuit duration is less than the target short circuit duration, calculate the second target peak voltage by decreasing the first target peak voltage based on the difference between the measured short circuit duration and the target short circuit duration.

In some example welding systems, the welding system further comprises a power source configured to generate the input power and a power source sensor configured to measure a state of the power source and generate a power source sensor signal comprising a measured power source response, wherein the control circuitry is further configured to: monitor the power source sensor signal during the background phase to determine whether the short circuit event occurred by detecting a power source response short circuit indication; and in response to determining that the short circuit event occurred by detecting the power source response short circuit indication, associate the short circuit event with one or more power source response short circuit parameters and determine the one or more second pulse parameters based on the one or more power source response short circuit parameters.

In some example welding systems, the welding system further comprises an audio sensor configured to measure audio feedback of the welding system and generate an audio sensor signal comprising a detected audio, wherein the control circuitry is further configured to: monitor the audio sensor signal during the background phase to determine whether the short circuit event occurred by detecting an audio short circuit indication; and in response to determining that the short circuit event occurred by detecting the audio short circuit indication, associate the short circuit event with one or more audio short circuit parameters and determine the one or more second pulse parameters based on the one or more audio short circuit parameters.

In some example welding systems, the welding system further comprises a spectrometer configured to measure a spectrographic emission of a welding arc of the weld circuit and generate a spectrometer signal comprising a measured spectrographic emission, wherein the control circuitry is further configured to: monitor the spectrometer signal during the background phase to determine whether the short circuit event occurred by detecting a spectrographic short circuit indication; and in response to determining that the short circuit event occurred by detecting the spectrographic short circuit indication, associate the short circuit event with one or more spectrographic short circuit parameters and determine the one or more second pulse parameters based on the one or more spectrographic short circuit parameters.

Disclosed example welding systems comprise: power conversion circuitry configured to convert input power to welding power and to output the welding power to a weld circuit; a voltage sensor configured to measure a voltage of the weld circuit and generate a voltage sensor signal comprising a measured voltage; and control circuitry configured to: control the power conversion circuitry to output the welding power according to one or more first welding parameters; monitor the voltage sensor signal while the power conversion circuitry outputs the welding power according to the one or more first welding parameters to determine whether a short circuit event occurred in the weld circuit by detecting that the measured voltage is greater than an anomalous cathode event voltage threshold; in response to determining that the short circuit event occurred, determine one or more second welding parameters based on the one or more first welding parameters and one or more short circuit parameters of the short circuit event; and control the power conversion circuitry to output the welding power according to the one or more second welding parameters.

In some example welding systems, the power conversion circuitry is configured to output the welding power according to at least one of: a gas-metal arc welding (GMAW) or metal inert gas welding (MIG) operation; a pulsed gas-metal arc welding (GMAW-P) or pulsed metal inert gas (pulse MIG) welding operation; a current-controlled welding operation; a voltage-controlled welding operation; a power-controlled welding operation; a resistance-controlled welding operation; an enthalpy-controlled welding operation; a tungsten inert gas welding (TIG) or gas tungsten arc welding (GTAW) operation; a flux cored arc welding (FCAW) operation; a shielded metal arc welding (SMAW) or stick welding operation; a plasma cutting operation; a plasma welding operation; a spray welding operation; a short circuit transfer welding operation; a pulse welding operation; or a pulsed spray welding operation.

In some example welding systems, the anomalous cathode event voltage threshold is greater than a target voltage of the one or more first welding parameters.

In some example welding systems, at least one of the one or more second welding parameters are configured to maintain an arc length of a welding arc of the weld circuit based on the one or more short circuit parameters and on a target arc length.

In some example welding systems, the control circuitry is further configured to compare the one or more short circuit parameters to one or more target short circuit parameters to determine one or more short circuit parameter target differences; and the determining of the one or more second welding parameters is based on the one or more first welding parameters and the one or more short circuit parameter target differences. In some such example welding systems, the determining of the one or more second welding parameters further comprises: in response to determining that a magnitude of at least one of the one or more short circuit parameter target differences is greater than a short circuit parameter target difference magnitude threshold, modifying at least one of the one or more first welding parameters based on the magnitude of the at least one of the one or more short circuit parameter target differences; and in response to determining that the magnitude of at least one of the one or more short circuit parameter target differences is not greater than the short circuit parameter target difference magnitude threshold, maintaining the one or more first welding parameters as the one or more second welding parameters.

In some example welding systems, the one or more first welding parameters comprise at least one of a first ramp up rate, a first wire feed speed, a first ramp down rate, a first target voltage, a first target current, a first target power, a first target resistance, a first target enthalpy, a first duration of one or more waveform phases, a first duration of a portion of a waveform, or a first waveform frequency; and the one or more second welding parameters comprise at least one of a second ramp up rate, a second ramp down rate, a second wire feed speed, a second target voltage, a second target current, a second target power, a second target resistance, a second target enthalpy, a second duration of the one or more waveform phases, a second duration of the portion of the waveform, or a second waveform frequency.

In some example welding systems, the one or more short circuit parameters comprise at least one of a measured short circuit duration, a predetermined short circuit duration, a measured short circuit voltage, a measured average short circuit voltage, a predetermined short circuit voltage, a measured short circuit current, a measured average short circuit current, or a predetermined short circuit current.

In some example welding systems, the control circuitry is further configured to, in response to determining that the short circuit event occurred by detecting that the measured voltage is greater than the anomalous cathode event voltage threshold, associate the short circuit event with one or more predetermined short circuit parameters associated with an anomalous cathode event and determine the one or more second welding parameters based on the one or more predetermined short circuit parameters. In some such example welding systems, the one or more predetermined short circuit parameters comprise a predetermined short circuit duration; the one or more first welding parameters comprise a first target voltage; the one or more second welding parameters comprise a second target voltage; and the control circuitry is further configured to: in response to determining that the predetermined short circuit duration is greater than a target short circuit duration, determine the second target voltage by increasing the first target voltage based on a difference between the predetermined short circuit duration and the target short circuit duration; and in response to determining that the predetermined short circuit duration is less than the target short circuit duration, determine the second target voltage by decreasing the first target voltage based on the difference between the predetermined short circuit duration and the target short circuit duration.

In some example welding systems, the control circuitry is further configured to, in response to determining that the short circuit event occurred by detecting that the measured voltage is greater than the anomalous cathode event voltage threshold, associate the short circuit event with one or more predetermined short circuit parameters associated with an anomalous cathode event and determine the one or more second welding parameters based on the one or more predetermined short circuit parameters; the one or more predetermined short circuit parameters comprise a predetermined short circuit duration; and the control circuitry is further configured to determine the predetermined short circuit duration based on a sampling rate of the voltage sensor.

In some example welding systems, the control circuitry is further configured to monitor the voltage sensor signal while the power conversion circuitry outputs the welding power according to the one or more first welding parameters to determine whether the short circuit event occurred in the weld circuit by detecting that the measured voltage is less than a short circuit detection voltage threshold. In some such example welding systems, the short circuit detection voltage threshold is less than a target voltage of the one or more first welding parameters.

In some example welding systems, the control circuitry is further configured to monitor the voltage sensor signal while the power conversion circuitry outputs the welding power according to the one or more first welding parameters to determine whether the short circuit event occurred in the weld circuit by detecting that the measured voltage is less than a short circuit detection voltage threshold; and the control circuitry is further configured to, in response to determining that the short circuit event occurred by detecting that the measured voltage is less than the short circuit detection voltage threshold, associate the short circuit event with one or more measured short circuit parameters and determine the one or more second welding parameters based on the one or more measured short circuit parameters. In some such example welding systems, the one or more measured short circuit parameters comprise a measured short circuit duration; the one or more first welding parameters comprise a first target voltage; the one or more second welding parameters comprise a second target voltage; and the control circuitry is further configured to: in response to determining that the measured short circuit duration is greater than a target short circuit duration, calculate the second target voltage by increasing the first target voltage based on a difference between the measured short circuit duration and the target short circuit duration; and in response to determining that the measured short circuit duration is less than the target short circuit duration, calculate the second target voltage by decreasing the first target voltage based on the difference between the measured short circuit duration and the target short circuit duration.

In some example welding systems, the short circuit event is a first short circuit event; the one or more short circuit parameters are one or more first short circuit parameters; and the control circuitry is further configured to: monitor the voltage sensor signal while the power conversion circuitry outputs the welding power according to the one or more second welding parameters to determine whether a second short circuit event occurred in the weld circuit by detecting that the measured voltage is greater than the anomalous cathode event voltage threshold; in response to determining that the second short circuit event occurred, determine one or more third welding parameters based on the one or more second welding parameters and one or more second short circuit parameters of the second short circuit event; and control the power conversion circuitry to output the welding power according to the one or more third welding parameters.

In some example welding systems, the one or more first welding parameters comprise one or more first pulse parameters of one or more first pulse cycles.

In some example welding systems, the welding system further comprises a power source configured to generate the input power and a power source sensor configured to measure a state of the power source and generate a power source sensor signal comprising a measured power source response, wherein the control circuitry is further configured to: monitor the power source sensor signal to determine whether the short circuit event occurred by detecting a power source response short circuit indication; and in response to determining that the short circuit event occurred by detecting the power source response short circuit indication, associate the short circuit event with one or more power source response short circuit parameters and determine the one or more second welding parameters based on the one or more power source response short circuit parameters.

In some example welding systems, the welding system further comprises an audio sensor configured to measure audio feedback of the welding system and generate an audio sensor signal comprising a detected audio, wherein the control circuitry is further configured to: monitor the audio sensor signal to determine whether the short circuit event occurred by detecting an audio short circuit indication; and in response to determining that the short circuit event occurred by detecting the audio short circuit indication, associate the short circuit event with one or more audio short circuit parameters and determine the one or more second welding parameters based on the one or more audio short circuit parameters.

In some example welding systems, further comprising a spectrometer configured to measure a spectrographic emission of a welding arc of the weld circuit and generate a spectrometer signal comprising a measured spectrographic emission, wherein the control circuitry is further configured to: monitor the spectrometer signal to determine whether the short circuit event occurred by detecting a spectrographic short circuit indication; and in response to determining that the short circuit event occurred by detecting the spectrographic short circuit indication, associate the short circuit event with one or more spectrographic short circuit parameters and determine the one or more second welding parameters based on the one or more spectrographic short circuit parameters.

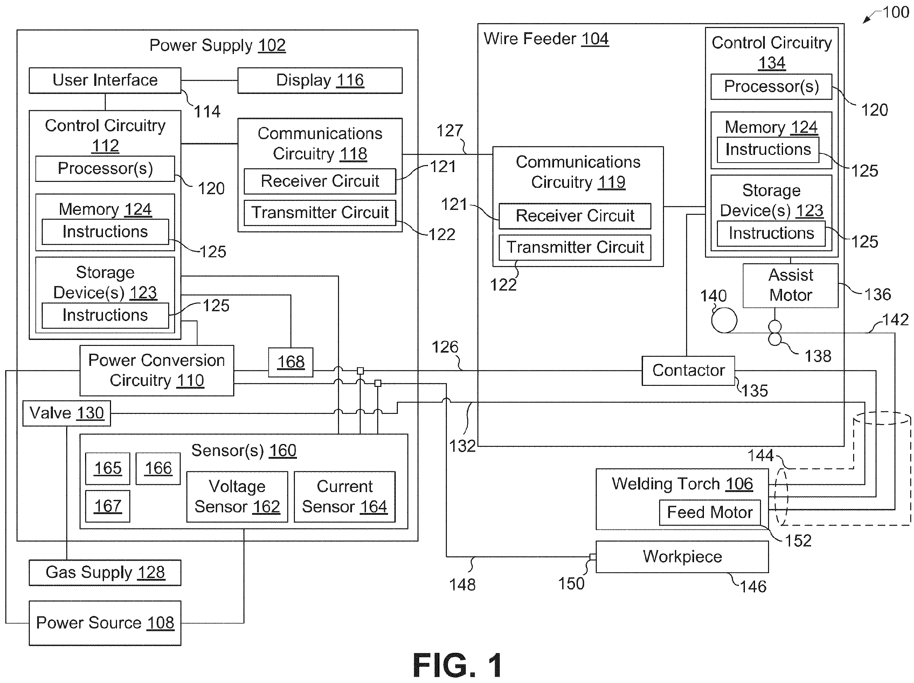

Turning now to the drawings, FIG. 1 is a block diagram of an example system 100. The system 100 is a welding system having a power supply 102, a wire feeder 104, and a welding torch 106. The system 100 powers, controls, and supplies consumables (e.g., an electrode) to a welding application. In some examples, the power supply 102 directly supplies input power to the welding torch 106. The welding torch 106 may be a torch configured for one or more welding modes, such as any, some, or all of GMAW/MIG, GMAW-P/pulsed MIG, SMAW/stick welding, current-controlled welding, voltage-controlled welding, power-controlled welding, resistance-controlled welding, enthalpy-controlled welding, TIG/GTAW, FCAW, plasma cutting, plasma welding, spray welding, short circuit transfer welding, pulse welding, pulsed spray welding, and/or one or more other welding modes based on the desired welding application.

In the example illustrated in FIG. 1, the power supply 102 is configured to supply welding power to the wire feeder 104, and the wire feeder 104 may be configured to route the welding power to the welding torch 106. In some examples, the wire feeder 104 also provides an electrode 142 (e.g., welding wire) to the welding torch 106, and the welding torch 106 may provide the welding power to the electrode 142, e.g., to create and/or maintain a welding arc between the electrode 142 and a workpiece 146. In addition to supplying an input power and/or the electrode 142 to the welding torch 106, the wire feeder 104 may supply a filler metal to a welding torch 106 for various welding applications (e.g., GMAW). While example of the system 100 depicted in FIG. 1 includes the wire feeder 104 (e.g., for GMAW operations), the wire feeder 104 may be replaced by any other type of remote accessory device, such as a stick welding and/or TIG welding remote control interface that provides stick and/or TIG welding.

The power supply 102 receives input power from a power source 108 (e.g., an engine, an electric motor, a generator, an AC power grid, a battery, one or more other energy-generating or - storage devices, and/or any combination thereof), conditions the input power, and provides an output power to one or more welding devices in accordance with demands of the system 100. The power source 108 may be supplied from an offsite location (e.g., the input power may originate from the power grid). The power supply 102 includes power conversion circuitry 110, which may include transformers, rectifiers, switches, and so forth, capable of converting the AC input power to AC and/or DC output power as dictated by the demands of the system 100 (e.g., particular welding processes and regimes) and/or by one or more aspects of the input power (e.g., frequency, voltage, current, etc.).

The power conversion circuitry 110 can convert input power (e.g., the input power received from the power source 108 as AC power) to welding power (e.g., DC power) and output the welding power to a weld circuit. For example, the power conversion circuitry 110 may output welding power to a weld circuit defined, at least in part, by the electrode 142 and the workpiece 146. In some examples, the power conversion circuitry 110 may output welding power based on one or more target weld parameters (e.g., one target welding parameter, a plurality of target welding parameters associated with one or more respective and/or distinct time values, etc.) to control the weld parameter according to the target value. For example, the power conversion circuitry 110 may output welding power based on one or more target voltages, one or more target currents, one or more target powers, one or more target resistances, one or more target enthalpies, and/or one or more other target welding parameters. In some examples, a target welding parameter may be determined and/or modified by, e.g., one or more control loops (e.g., when power conversion circuitry is operating in a voltage-controlled mode, a current-controlled mode, an enthalpy-controlled mode, a power-controlled mode, a resistance-controlled mode, etc.), control circuitry, one or more setpoints, etc. In some examples, the power conversion circuitry 110 is configured to convert the input power received from the power source 108 to both welding power and one or more auxiliary power outputs. An auxiliary power may include, e.g., an arc starting power (e.g., a power configured to initiate an arc between the electrode 142 and the workpiece 146) and/or an input power for a one or more auxiliary devices (e.g., a sensor, a computing device, a light, a grinder, etc.).

The power supply 102 includes control circuitry 112 to control the operation of the power supply 102. The power supply 102 also includes a user interface 114. The control circuitry 112, which is also referred to as a "controller," receives input from the user interface 114, through which a user may choose a process and/or input desired parameters (e.g., voltages, currents, resistances, enthalpies, powers, wire feed speeds, short circuit durations, arc lengths, one or more other setpoints, particular pulsed or non-pulsed welding regimes, and so forth). The user interface 114 may receive inputs using any input device, such as via a keypad, keyboard, buttons, touch screen, voice activation system, wireless device, etc. Furthermore, the control circuitry 112 controls operating parameters based on input by the user as well as based on other current operating parameters. Specifically, the user interface 114 may include a display 116 for presenting, showing, or indicating, information to an operator. The control circuitry 112 may also include interface circuitry for communicating data to other devices in the system 100, such as the wire feeder 104. For example, in some situations, the power supply 102 wirelessly communicates with other welding devices within the system 100. Further, in some situations, the power supply 102 communicates with other welding devices using a wired connection, such as by using a network interface controller (NIC) to communicate data via a network (e.g., ETHERNET, 10baseT, 10base100, etc.). In the example of FIG. 1, the control circuitry 112 communicates with the wire feeder 104 via the weld circuit via communications circuitry 118, as described below.

The control circuitry 112 includes at least one controller or processor 120 that controls the operations of the power supply 102. The control circuitry 112 receives and processes multiple inputs associated with the performance and demands of the system 100. The processor 120 may include one or more microprocessors, such as one or more "general-purpose" microprocessors, one or more special-purpose microprocessors and/or ASICS, and/or any other type of processing device. For example, the processor 120 may include one or more digital signal processors ("DSPs").

The example control circuitry 112 includes one or more storage device(s) 123 and one or more memory device(s) 124. The storage device(s) 123 (e.g., nonvolatile storage, one or more non-transitory computer-readable medium(s)) may include ROM, flash memory, a hard drive, and/or any other suitable optical, magnetic, and/or solid-state storage medium(s), and/or a combination thereof. The storage device 123 stores data (e.g., data corresponding to a welding application), instructions (e.g., software or firmware to perform welding processes), and/or any other appropriate data. Examples of stored data for a welding application include an attitude (e.g., orientation) of a welding torch (e.g., the welding torch 106), a distance between the contact tip and a workpiece (e.g., the workpiece 146), a voltage, a current, welding device settings, and so forth.

The memory device 124 may include a volatile memory, such as random access memory (RAM), and/or a nonvolatile memory, such as read-only memory (ROM). The memory device 124 and/or the storage device(s) 123 may store a variety of information and may be used for various purposes. For example, the memory device 124 and/or the storage device(s) 123 may store processor executable instructions 125 (e.g., firmware or software) for the processor 120 to execute. In addition, one or more control regimes for various welding processes, along with associated settings and parameters, may be stored in the storage device 123 and/or memory device 124, along with code configured to provide a specific output (e.g., initiate wire feed, enable gas flow, capture welding current data, detect short circuit parameters, determine amount of spatter) during operation.

In some examples, the welding power flows from the power conversion circuitry 110 through a weld cable 126 to the wire feeder 104 and the welding torch 106. The example weld cable 126 is attachable and detachable from weld studs at each of the power supply 102 and the wire feeder 104 (e.g., to enable ease of replacement of the weld cable 126 in case of wear or damage). Furthermore, in some examples, welding data is provided with the weld cable 126 such that welding power and weld data are provided and transmitted together over the weld cable 126. The communications circuitry 118 may be communicatively coupled to the weld cable 126 to communicate (e.g., send/receive) data over the weld cable 126. The communications circuitry 118 may be implemented based on various types of power line communications methods and techniques. For example, the communications circuitry 118 may utilize IEEE standard P1901.2 to provide data communications over the weld cable 126. In this manner, the weld cable 126 may be utilized to provide welding power from the power supply 102 to the wire feeder 104 and the welding torch 106. Additionally or alternatively, a communication cable 127 may be used to transmit and/or receive data communications between the communications circuitry 118 and a similar communications circuitry 119 of the wire feeder 104.

The example communications circuitry 118 includes a receiver circuit 121 and a transmitter circuit 122. Generally, the receiver circuit 121 receives data transmitted by the wire feeder 104 and the transmitter circuit 122 transmits data to the wire feeder 104. In some examples, the receiver circuit 121 receives communication(s) via the weld circuit while weld current is flowing through the weld circuit (e.g., during a welding operation) and/or after the weld current has stopped flowing through the weld circuit (e.g., after a welding operation).

The example wire feeder 104 also includes a communications circuitry 119, which may be similar or identical in construction and/or function as the communications circuitry 118.

The example power supply 102 includes and/or is communicatively coupled to one or more sensors 160. Each of the one or more sensors 160 measure one or more parameters (e.g., an aspects, a quality, a state, etc.) of one or more devices, systems, components, etc. of the system 100 and/or of power (e.g., input power), received by and/or output by the system 100 and/or one or more devices, systems, components, etc. thereof.

In the example of FIG. 1, the one or more sensors 160 include a voltage sensor 162. The voltage sensor 162 measures a voltage (e.g., an output voltage from the power supply 102 and/or a voltage from one or more other points and/or components of the weld circuit) and generates a voltage sensor signal which includes a measured voltage (e.g., measured in volts ("V")). The voltage sensor 162 provides the voltage sensor signal to the control circuitry 112, e.g., such that the control circuitry 112 may monitor the voltage sensor signal and, thereby, the measured voltage. The output voltage of the power supply 102 may be controlled by the power conversion circuitry 110, an external voltage source, an external current source, and/or load, and/or any other internal or external cause of voltage. The voltage sensor 162 may include, e.g., a voltmeter, a feedback loop, etc. While the example of the voltage sensor 162 is illustrated in FIG. 1 as monitoring the output voltage from the power conversion circuitry 110, the voltage sensor 162 may be configured to monitor any voltage from the output terminals of the power supply 102 and/or for any particular circuits.

In the example of FIG. 1, the one or more sensors 160 include a current sensor 164. The current sensor 164 measures a current (e.g., an output current from the power supply 102 and/or a current from one or more other points and/or components of the weld circuit) and generates a current sensor signal which includes a measured current (e.g., measured in amps ("A")). The current sensor 164 provides the current sensor signal to the control circuitry 112, e.g., such that the control circuitry 112 may monitor the current sensor signal and, thereby, the measured current. The output current of the power supply 102 may be controlled by the power conversion circuitry 110, an external voltage source, current source, and/or load, and/or any other internal or external cause of current. The current sensor 164 may include, e.g., an ammeter, a feedback loop, etc. While the example of the current sensor 164 is illustrated in FIG. 1 as monitoring the output current from the power conversion circuitry 110, the current sensor 164 may be configured to monitor any currents flowing through the output terminals of the power supply 102 and/or for any particular circuits.

In some examples, the one or more sensors 160 include either or both of the voltage sensor 162 and/or the current sensor 164. In some examples, the one or more sensors 160 additionally and/or alternatively include one or more other sensors, such as a wire feed speed sensor (e.g., a photoelectric speed sensor, a tachometer, an encoder, etc.), power source sensor 165, an audio sensor 166, and/or a spectrometer 167. In some examples, the power source sensor 165 is configured to measure a state (e.g., a load, control of an inverter, etc.) of the power source 108 (e.g., an engine, an electric motor, etc.). In some examples, the audio sensor 166 is configured to measure audio feedback of the system 100 (e.g., sounds produced by a welding operation, an arc between the electrode 142 and the workpiece 146, etc.). In some examples, the spectrometer 167 is configured to measure a spectrographic emission (e.g., color and/or luminosity of light) of a welding arc of a weld circuit of the system 100.

In some examples, a gas supply 128 provides shielding gases, such as argon, helium, carbon dioxide, and so forth, depending upon the welding application. The shielding gas flows to a valve 130, which controls the flow of gas, and if desired, may be selected to allow for modulating or regulating the amount of gas supplied to a welding application. The valve 130 may be opened, closed, or otherwise operated by the control circuitry 112 to enable, inhibit, or control gas flow (e.g., shielding gas) through the valve 130. Shielding gas exits the valve 130 and flows through a cable 132 (which in some implementations may be packaged with the welding power output) to the wire feeder 104 which provides the shielding gas to the welding application. In some examples, the system 100 does not include the gas supply 128, the valve 130, and/or the cable 132.

In some examples, the wire feeder 104 uses the welding power to power the various components in the wire feeder 104, such as to power a wire feeder control circuitry 134. As noted above, the weld cable 126 may be configured to provide or supply the welding power. The power supply 102 may also communicate with communications circuitry 119 of the wire feeder 104 using the weld cable 126 and the communications circuitry 118 disposed within the power supply 102. In some examples, the communications circuitry 119 is substantially similar to the communications circuitry 118 of the power supply 102. The wire feeder control circuitry 134 controls the operations of the wire feeder 104. In some examples, the wire feeder 104 uses the wire feeder control circuitry 134 to detect whether the wire feeder 104 is in communication with the power supply 102 and to detect a current welding process of the power supply 102 if the wire feeder 104 is in communication with the power supply 102.

A contactor 135 (e.g., high amperage relay) is controlled by the wire feeder control circuitry 134 and configured to enable or inhibit welding power to continue to flow to the weld cable 126 for the welding application. In some examples, the contactor 135 is an electromechanical device. However, the contactor 135 may be any other suitable device, such as a solid-state device, and/or may be omitted when the power supply 102 is configured to control the output of welding power to the welding torch 106. The control circuitry 112 and/or the wire feeder control circuitry 134 may control the contactor 135 to close and/or open to provide power to the welding torch 106. The wire feeder 104 includes an assist motor 136 that receives control signals from the wire feeder control circuitry 134 to drive rollers 138 that rotate to pull the electrode 142 (e.g., welding wire) off a spool 140. The spool 140 may be, e.g., a spool of wire when the electrode 142 is welding wire. The spool 140 may be any mechanically-retrievable storage mechanism for the electrode 142. The electrode 142 is provided to the welding application through a torch cable 144. Likewise, the wire feeder 104 may provide the shielding gas from the cable 132 through the torch cable 144. The electrode 142, the shield gas, and the power from the weld cable 126 may be bundled together in a single one of the torch cable 144, in multiple ones of the torch cable 144, and/or individually provided to the welding torch 106.

The welding torch 106 delivers the electrode 142, welding power, and/or shielding gas for a welding application. The welding torch 106 is used to establish a welding arc between the welding torch 106 and the workpiece 146. A work cable 148 couples the workpiece 146 to the power supply 102 (e.g., to the power conversion circuitry 110) to provide a return path for the weld current (e.g., as part of the weld circuit). The example work cable 148 is attachable and/or detachable from the power supply 102 for ease of replacement of the work cable 148. The work cable 148 may be terminated with a clamp 150 (or another power connecting device), which couples the power supply 102 to the workpiece 146.

The example welding torch 106 includes a feed motor 152, which is configured to pull the electrode 142 from the wire feeder 104 to the welding torch 106 to feed the wire to a welding arc during welding operations. The feed motor 152 may be controlled to advance the electrode 142 at one or more wire feed speeds (e.g., a speed at which the wire feeder 104 feeds the electrode 142 to the welding torch 106). The feed motor 152 may also be controlled to hold the electrode 142 in a stopped condition. When controlled to hold the electrode 142 in a stopped condition, the feed motor 152 is controlled to neither advance nor retract the electrode 142 relative to the feed motor 152. Rather, when controlled to hold the electrode 142 in the stopped condition, the feed motor 152 is controlled to hold the electrode 142 in place relative to the feed motor 152. Changing wire speeds may be used in some welding processes to reduce spatter and/or achieve desired welding results.

The assist motor 136 may operate as an assist motor to pull the electrode 142 from the spool 140 and feed the electrode 142 toward the welding torch 106, while the example feed motor 152 advances the electrode 142 and/or holds the electrode 142 in a stopped condition to control short circuiting and/or arc length during welding. In examples, either or both the feed motor 152 and/or the assist motor 136 are not capable of retracting the electrode 142. In other examples, either or both of the feed motor 152 and/or the assist motor 136 are capable of retracting the electrode 142. In some examples, the welding torch 106 does not include the feed motor 152. In some examples, the wire feeder 104 does not include the assist motor 136.

The control circuitry 112 may control one or more components, devices, systems, etc. of the system 100 (e.g., the power conversion circuitry 110, the wire feeder 104, and/or the welding torch 106) according to one or more welding parameters. As used herein, the term "welding parameter" includes any measurable, modifiable, configurable, or otherwise controllable aspect, output, or process of a welding system during one or more time intervals of some or all of a welding operation (e.g., a GMAW/MIG operation, a GMAW-P/pulsed MIG operation, an SMAW/stick welding operation, a current-controlled welding operation, a voltage-controlled welding operation, a power-controlled welding operation, an enthalpy-controlled welding operation, a resistance-controlled enthalpy operation, a TIG/GTAW welding operation, an FCAW operation, a plasma cutting operation, a plasma welding operation, a spray welding operation, a short circuit transfer welding operation, a pulse welding operation, a pulsed spray welding operation, and/or one or more other welding modes). For example, the term "welding parameter" can include one or more voltages (measured in, e.g., volts ("V")) of a weld circuit and/or of welding power output by power conversion circuitry (e.g., a target voltage, a measured voltage, a determined voltage, an output voltage, etc.), one or more currents (measured in, e.g., amps ("A")) of a weld circuit and/or of welding power output by power conversion circuitry (e.g., a target current, a measured current, a determined current, an output current, etc.), one or more frequencies (measured in, e.g., hertz ("Hz")) of a weld circuit and/or of welding power output by power conversion circuitry (e.g., a target frequency, a measured frequency, a determined frequency, an output frequency, etc.), one or more powers (measured in, e.g., watts ("W")) of a weld circuit and/or of welding power output by power conversion circuitry (e.g., a target power, a measured power, a determined power, an output power, etc.), one or more resistances (measured in, e.g., ohms) of a weld circuit (e.g., a target resistance, a measured resistance, a determined resistance, etc.), one or more enthalpies (measured in, e.g., Joules ("J")) of a weld circuit and/or of welding power output by power conversion circuitry (e.g., a target enthalpy, a measured enthalpy, a determined enthalpy, an output enthalpy, etc.), one or more wire feed speeds (measured in, e.g., meters per second ("mps"), inches per minute ("ipm"), etc.) of a wire feeder (e.g., a target wire feed speed, a measured wire feed speed, an output wire feed speed, etc.), a ramp up rate (e.g., a rate at which a voltage, current, power, resistance, enthalpy, etc. is increased from one value to a target value and/or to a setpoint value) of welding power output by power conversion circuitry, a ramp down rate (e.g., a rate at which a voltage, current, power, resistance, enthalpy, etc. is decreased from one value to a target value and/or to a setpoint value) of welding power output by power conversion circuitry, one or more other measurable electric and/or electromagnetic aspects of a weld circuit or welding power output by power conversion circuitry, one or more short circuit durations of one or more short circuits of a weld circuit (e.g., a measured short circuit duration, a predetermined short circuit duration, a target short circuit duration, a determined short circuit duration, etc.), one or more arc lengths of a welding arc of a weld circuit (e.g., a measured arc length, a predetermined arc length, a target arc length, a determined arc length, etc.), one more welding waveforms, one or more durations of a phase of a waveform, one or more durations of one or more other portions of a waveform (e.g., a wavelength of a welding waveform, one or more durations of one or more intervals and/or portions of a welding waveform, etc.), one or more waveform frequencies (e.g., a number of one or more intervals and/or portions of a welding waveform that occur in a set amount of time, etc.), one or more operating modes of power conversion circuitry (e.g., a voltage-controlled mode, a current-controlled mode, a power-controlled mode, a resistance-controlled mode, an enthalpy-controlled mode, etc.), one or more pulse parameters of one or more pulse cycles, and/or one or more other measurable, modifiable, configurable, or otherwise controllable aspects, outputs, and/or processes of a welding system (e.g., the system 100).

As used herein, the term "pulse parameter" includes one or more welding parameters of one or more pulse cycles (e.g., one or more pulse cycles according to which the control circuitry 112 controls the power conversion circuitry 110 to output welding power) of a welding operation (e.g., a pulsed welding operation, a GMAW/MIG operation, a GMAW-P/pulsed MIG operation, a pulsed spray welding operation, and/or one or more other welding modes). For example, the term "pulse parameter" can include one or more pulse widths (e.g., a duration of a peak phase of a pulse cycle), one or more pulse frequencies (e.g., a number of pulses occurring in a set amount of time), one or more target peak voltages (e.g., a target voltage of at least a portion of a peak phase of a pulse cycle), one or more target background voltages (e.g., a target voltage of at least a portion of a background phase of a pulse cycle), one or more other target voltages (e.g., one or more target voltages of one or more phases of a pulse cycle), one or more target peak currents (e.g., a target current of at least a portion of a peak phase of a pulse cycle), one or more target background currents (e.g., a target current of at least a portion of a background phase of a pulse cycle), one or more other target currents (e.g., one or more target currents of one or more phases of a pulse cycle), one or more ramp up rates (e.g., a ramp up rate of a beginning of a peak phase as a welding parameter is controlled to increase from a target background value to a target peak value), one or more ramp down rates (e.g., a ramp down rate of a beginning of a background phase as a welding parameter is controlled to decrease from a target peak value to a target background value), one or more target powers (e.g., a peak power, a background power, etc.), one or more target resistances (e.g., a peak resistance, a background resistance, etc.), one or more target enthalpies (e.g., a peak enthalpy, a background enthalpy, etc.), one or more other target values (e.g., any measurable value of a weld circuit, of welding power output by power conversion circuitry, and/or of a welding operation), and/or one or more other measurable and/or modifiable aspects, processes, and/or values of one or more pulse cycles.

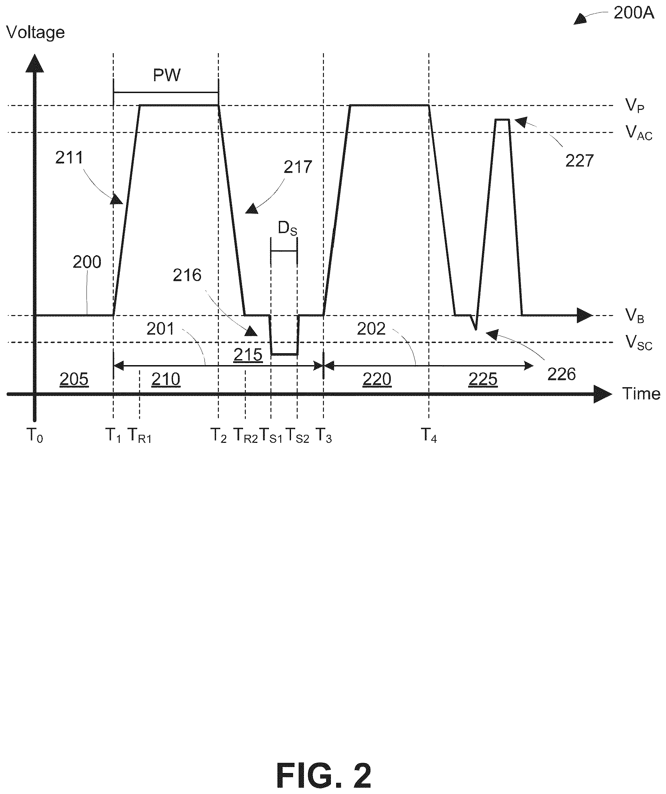

FIG. 2 depicts a graph (x-axis: time; y-axis: voltage) of an example of a waveform 200A of a voltage 200 of the system 100 (measured by, e.g., the voltage sensor 162) during example pulse cycles. The waveform 200A is depicted in FIG. 2 as including substantially constant values and substantially constant rates of change during some time intervals, but such depictions are for illustrative purposes only. In some examples, a current and/or voltage (e.g., measured by either or both of the sensors 162, 164) may vary during one or more time intervals in one or more ways not depicted in and/or indicated by FIG. 2. For example, relative proportions of voltage levels (e.g., target peak voltages, target background voltages, voltage levels of short circuits, voltage levels of anomalous cathode events, etc.), voltage rates of change (e.g. one or more ramp up rates, one or more ramp down rates, one or more rates of change to or from voltage levels of a short circuit, one or more rates of change to or from voltage levels of an anomalous cathode event, etc.), or durations (e.g., durations of one or more peak phases, durations of one or more background phases, durations of one or more short circuits, durations of one or more anomalous cathode events, etc.) depicted in FIG. 2 are purely illustrative and may, in various embodiments, vary from the relative proportions depicted in FIG. 2.

In FIG. 2, a first pulse cycle 201 starts at a first time (T₁) and ends at a third time (T₃). The first pulse cycle 201 is followed by a second pulse cycle 202 that starts at the third time (T₃). The first pulse cycle 201 includes a first peak phase 210, from the first time (T₁) to a second time (T₂), and a first background phase 215, from the second time (T₂) to the third time (T₃). The second pulse cycle 202 includes a second peak phase 220, from the third time (T₃) to a fourth time (T₄), and a second background phase 225, starting at a fourth time (T₄). Each of the peak phases 210, 220 are defined by a pulse width, indicated by a pulse width (PW) in FIG. 2, and a target peak voltage, indicated by a peak voltage (V_{P}) in FIG. 2 (e.g., a target voltage of the peak phases 210, 220). Each of the background phases 215, 225 are defined by a background phase duration and a target background voltage, indicated by a background voltage (V_{B}) in FIG. 2 (e.g., a target voltage of the background phases 215, 225).

While FIG. 2 depicts each of the peak phases 210, 220 as having the same pulse width (PW) and the same peak voltage (V_{P}), in some examples one or more peak phases of one or more pulse cycles may have one or more different pulse widths and/or one or more different target peak voltages. While FIG. 2 depicts each of the background phases 215, 225 as having the same background voltage (V_{B}), in some examples one or more background phases of one or more pulse cycles may have one or more different background phase durations and/or one or more different target background voltages. In some examples, one or more peak phases may have one or more target peak currents, one or more target peak voltages, one or more target peak enthalpies, one or more target peak resistances, one or more target peak powers, and/or one or more other target peak values in addition to and/or alternative to one or more target peak voltages. In some examples, one or more background phases may have one or more target background currents, one or more target background enthalpies, one or more target background resistances, one or more target background powers, and/or one or more other target background values in addition to and/or alternative to one or more target background voltages.

The control circuitry 112 may control the power conversion circuitry 110 to output welding power in a voltage-controlled mode, a current-controlled mode, a power-controlled mode, an enthalpy-controlled mode, a resistance-controlled mode, and/or one or more other welding parameter-controlled modes during at least one or more portions of one or more phases (e.g., any, some, or all of the phases 210, 215, 220, 225, one or more other peak phases, one or more other background phases, one or more other phases, etc.), one or more portions of one or more pulse cycles (e.g., the pulse cycles 201, 202, one or more other pulse cycles, etc.), one or more portions of one or more welding waveforms, and/or one or more other portions of a welding operation (e.g., GMAW, GMAW-P, TIG, FCAW, SMAW, plasma cutting, plasma welding, spray welding, short circuit transfer welding, pulse welding, pulsed spray welding, etc.). When controlling the power conversion circuitry 110 to output welding power in, e.g., a voltage-controlled mode, the control circuitry 112 controls the power conversion to increase or decrease the output current (e.g., measured in amps) and/or one or more other welding parameters (e.g., power, resistance, enthalpy, etc.) of the power conversion circuitry 110 based on a difference between measured voltage (e.g., measured by the voltage sensor 162) and a target voltage. When controlling the power conversion circuitry 110 to output welding power in, e.g., a current-controlled mode, the control circuitry 112 controls the power conversion circuitry 110 to increase or decrease the output voltage (e.g., measured in volts) and/or one or more other welding parameters (e.g., power, resistance, enthalpy, etc.) of the power conversion circuitry 110 based on the difference between a measured current (e.g., measured by the current sensor 164) and a target current.

In some examples, the control circuitry 112 controls the power conversion circuitry 110 to output welding power in a first controlled mode (e.g., a current-controlled mode) during a first portion of a pulse cycle and in a second controlled mode (e.g., a voltage-controlled mode) during a second portion of a pulse cycle. In some such examples, the control circuitry 112 controls the power conversion circuitry 110to output welding power in a first controlled mode (e.g., a current-controlled mode) during some or all of a ramping up period of a phase (e.g., as voltage transitions from a target background voltage to a target peak voltage in a beginning of a peak phase) and in a second controlled mode (e.g., a voltage-controlled mode) during some or all of a remainder of the phase (e.g., a remaining portion of a peak phase between a ramping up period and a subsequent phase). For example, in the first pulse cycle 201 of FIG. 2, the control circuitry 112 controls the power conversion circuitry 110 to output welding power in a current-controlled mode during some or all of a ramping up period 211 from the first time (T₁) until a first ramp time (T_{R1}), and, also in the example of FIG. 2, the control circuitry 112 controls the power conversion circuitry 110 to output welding power in a voltage-controlled mode for some or all of a portion of the first peak phase 210 between the first ramp time (T_{R1}) and the second time (T₂). The ramping up period 211 may include some or all of a period of the first peak phase 210 in which the voltage 200 changes from the background voltage (V_{B}) of an initial background phase 205 to the peak voltage (V_{P}) of the first peak phase 210. In some additional and/or alternative examples, the control circuitry 112 controls the power conversion circuitry 110 to output welding power in a first controlled mode (e.g., a current-controlled mode) during some or all of a ramping down period of a phase (e.g., as voltage transitions from a target peak voltage to a target background voltage in a beginning of a background phase) and in a second controlled mode (e.g., a voltage-controlled mode) during some or all of a remainder of the phase (e.g., a remaining portion of a background phase between a ramping down period and a subsequent phase). For example, in the first pulse cycle 201 of FIG. 2, the control circuitry 112 controls the power conversion circuitry 110 to output welding power in a current-controlled mode during some or all of a ramping down period 217 from the second time (T₂) until a second ramp time (T_{R2}), and, also in the example of FIG. 2, the control circuitry 112 controls the power conversion circuitry 110 to output welding power in a voltage-controlled mode for some or all of a portion of the first background phase 215 between the second ramp time (T_{R2}) and the third time (T₃). The ramping down period 217 may include some or all of a period of the first background phase 215 in which the voltage 200 changes from the peak voltage (V_{P}) of the first peak phase 210 to the background voltage (V_{B}) of the first background phase 215.

In some examples, the control circuitry 112 may determine whether a short circuit event (e.g., a molten ball briefly joining the electrode 142 and the workpiece 146) has occurred in one or more ways. In some examples, the control circuitry 112 monitors one or more sensor signals (e.g., a sensor signal generated by the voltage sensor 162) to determine whether a short circuit event has occurred by detecting that a measured voltage is less than a short circuit detection voltage threshold (V_{SC}). The short circuit detection voltage threshold (V_{SC}) may be a predetermined voltage level that is, e.g., less than the background voltage (V_{B}). In response to determining that a short circuit event has occurred, the control circuitry 112 may determine one or more short circuit parameters (e.g., a short circuit duration, a minimum short circuit voltage, etc.) of the short circuit event (e.g., based on the one or more sensor signals). For example, the control circuitry 112 may determine that a first short circuit event 216 has occurred by detecting the voltage 200 as being less than the short circuit detection voltage threshold (V_{SC}) during the first background phase 215. In the example of FIG. 2, the control circuitry 112 determines a short circuit duration of the first short circuit event 216 as being an amount of time between a short circuit start time (T_{S1}) and a short circuit end time (T_{S2}) determined by the control circuitry 112. In some examples, the control circuitry 112 may determine the short circuit start time (T_{S1}) as being a time at which the voltage 200 is first measured as being less than the short circuit detection voltage threshold (V_{SC}). In some examples, the control circuitry 112 may determine the short circuit end time (T_{S2}) as being a time at which the voltage 200 returns to the background voltage (V_{B}), returns to being within a predetermined proximity (e.g., a percentage, a number of volts, etc.) of the background voltage (V_{B}), and/or returns to being greater than the short circuit detection voltage threshold (V_{SC}). In some examples, the short circuit end time (T_{S2}) is detected when the voltage 200 has exceeded the short circuit detection threshold (V_{SC}) and/or one or more other threshold voltages for at least a threshold time duration or threshold number of samples (e.g., discrete measured voltage values measured by the voltage sensor 162).

In some examples, the short circuit end time (T_{S2}) is detected when the voltage 200 has exceeded one or more threshold voltages other than and/or in addition to the short circuit detection threshold (V_{SC}). In some examples, the control circuitry 112 detects the short circuit end time (T_{S2}) when the voltage 200 has returned to the background voltage (V_{B}). In some examples, the control circuitry 112 detects the short circuit end time (T_{S2}) when the voltage 200 has exceeded an arc detection voltage (e.g., a voltage level different than the short circuit detection threshold (V_{SC})). For example, the control circuitry 112 may determine the arc detection voltage based on a current (e.g., a measured current, target current, output current, etc.) and/or one or more other welding parameters of the welding power output by the power conversion circuitry 110 and/or of the weld circuit, e.g., by calculating and/or modifying the arc detection voltage as a function of the magnitude of the current as the current initiates and/or changes over time.

In some examples, the control circuitry 112 may additionally and/or alternatively determine whether a short circuit event has occurred by comparing one or more measurements of one or more other parameters (e.g., one or more parameters in addition to and/or alternative to voltage) to one or more other short circuit detection thresholds. In some examples, the control circuitry 112 may determine a determined voltage (based on, e.g., a current measured by the current sensor 164) rather than measure a measured voltage, and, in some such examples, the control circuitry 112 may compare the determined voltage to the short circuit detection voltage threshold (V_{SC}). In some examples, the short circuit detection voltage threshold (V_{SC}) may be a predetermined value (e.g., a setpoint), a value received via the communications circuitry 118, and/or a value received via the user interface 114. In some examples, the control circuitry 112 may determine the short circuit detection voltage threshold (V_{SC}) based on one or more welding parameters of the welding power, such as by calculating the short circuit detection voltage threshold (V_{SC}) as a percentage of the background voltage (V_{B}), as a percentage of the peak voltage (V_{P}), as a predetermined amount less than the background voltage (V_{B}), and/or as a predetermined amount less than the peak voltage (V_{P}).

Some short circuit events (e.g., very brief short circuit events), however, may not result in a voltage measurement that is less than the short circuit detection voltage threshold (V_{SC}). For example, a second short circuit event 226 does not result in a measurement of the voltage 200 that is less than the short circuit detection voltage threshold (V_{SC}) (e.g., by having a more brief short circuit duration than the first short circuit event 216), and so the control circuitry 112 does not determine that a short circuit event has occurred based on the short circuit detection voltage threshold (V_{SC}). Nonetheless, the second short circuit event 226 is followed by an anomalous cathode event 227, as evidenced by a spike in the voltage 200 following the (otherwise undetected) short circuit of the second short circuit event 226.

It should be understood that, during the second short circuit event 226 and/or at least some other short circuit events that do not result in a measurement of a voltage that is less than the short circuit detection voltage threshold (V_{SC}) (or a measurement of another welding parameter that is greater than or less than another short circuit detection threshold), the voltage (or other welding parameter) may, nonetheless, have actually fallen below the short circuit detection voltage threshold (V_{SC}) (or fallen below or exceeded another short circuit detection threshold). Rather, if a short circuit duration of a short circuit is less than a sampling rate of a sensor measuring a welding parameter used to detect a short circuit event, then, if the duration of the short circuit occurs entirely within the time between two sampling intervals of the sensor, measured values generated by the sensor may not indicate the occurrence the short circuit. For example, the voltage sensor 162 may measure a voltage of the weld circuit at a sampling rate of 50 microseconds ("µs"), sampling at a first time t=0 µs and at a second time t=50 µs, and a short circuit having a short circuit duration of 25 µs may occur from a time t=10 µs until a time t= 35 µs. In this example, even if the voltage of the weld circuit fell below the short circuit detection voltage threshold (V_{SC}) during the duration of the short circuit, measured voltages measured by the voltage sensor 162 may, nonetheless, indicate that the voltage did not fall below the short circuit detection voltage threshold (V_{SC}), as the voltage sensor 162 only measured the voltage of the weld circuit before and after (rather than during) the short circuit.

In some examples, the control circuitry 112 monitors one or more sensor signals (e.g., a sensor signal generated by the voltage sensor 162) to determine whether a short circuit event has occurred by detecting that a measured voltage is greater than an anomalous cathode event voltage threshold (V_{AC}) (e.g., determining that an anomalous cathode event has occurred). The anomalous cathode event voltage threshold (V_{AC}) may be a predetermined voltage level that is, e.g., greater than the background voltage (V_{B}). In some examples, the anomalous cathode event voltage threshold (V_{AC}) is less than the peak voltage (V_{P}). In some examples, the anomalous cathode event voltage threshold (V_{AC}) is greater than the peak voltage (V_{P}). In response to determining that an anomalous cathode event has occurred, the control circuitry 112 may determine one or more short circuit parameters (e.g., a short circuit duration, a minimum short circuit voltage, etc.) of a short circuit event associated with the anomalous cathode event. If the control circuitry 112 has determined that an anomalous cathode event has occurred without determining that a short circuit event has occurred by an alternative mechanism (e.g., by not detecting that a voltage of the welding power was less than the short circuit detection voltage threshold (V_{SC})), the control circuitry 112 may associate the short circuit event with one or more predetermined short circuit parameters. For example, the control circuitry 112 may associate the short circuit event with a predetermined short circuit duration, e.g., because the control circuitry 112 did not otherwise measure or determine a short circuit duration. A predetermined short circuit duration may be, e.g., greater than or equal to 1 µs, less than or equal to 100 µs, less than or equal to 50 µs, less than or equal to 10 µs, greater than or equal to 1 µs and less than or equal to 100 µs, greater than or equal to 1 µs and less than or equal to 50 µs, and/or greater than or equal to 1 µs and less than or equal to 10 µs.

In some examples, the predetermined short circuit duration may be determined based on one or more sampling rates of one or more sensors used to detect short circuit events and/or anomalous cathode events. For example, the control circuitry 112 may determine the predetermined short circuit duration based on a sampling rate of the voltage sensor 162 by, e.g., calculating the predetermined short circuit duration to be a percentage of the sampling rate of the voltage sensor 162 or a predetermined amount less than the sampling rate of the voltage sensor 162. Accordingly, if the voltage sensor 162 has a sampling rate of 25 µs (e.g., the voltage sensor 162 samples a voltage of the weld circuit ever 25 µs), the control circuitry 112 may determine the predetermined short circuit duration to be, e.g., 10 µs.

In the example of FIG. 2, the control circuitry 112 may determine that the second short circuit event 226 has occurred by detecting the voltage 200 as being greater than the anomalous cathode event voltage threshold (V_{AC}) during the second background phase 225. The control circuitry 112 did not, however, detect the second short circuit event 226 by determining that the voltage 200 was less than the short circuit detection voltage threshold (V_{SC}), and so, in the example of FIG. 2, the control circuitry 112 does not determine a short circuit duration of the second short circuit event 226 based on the voltage 200. Rather, the control circuitry 112 associates the second short circuit event 226 with a predetermined short circuit duration (e.g., a short circuit duration less than the short circuit duration of the first short circuit event 216).

In some examples, the control circuitry 112 may additionally and/or alternatively determine whether an anomalous cathode event has occurred by comparing one or more measurements of one or more other parameters (e.g., one or more parameters in addition to and/or alternative to voltage) to one or more other anomalous cathode detection thresholds. In some examples, the anomalous cathode voltage threshold (V_{AC}) may be a predetermined value (e.g., a setpoint), a value received via the communications circuitry 118, and/or a value received via the user interface 114. In some examples, the control circuitry 112 determines an anomalous cathode threshold based on one or more welding parameters of the welding power. For example, the control circuitry 112 may determine the anomalous cathode voltage threshold (V_{AC}) by calculating the anomalous cathode voltage threshold (V_{AC}) as a percentage of the background voltage (V_{B}) (e.g., 120% of the background voltage (V_{B}), etc.), as a percentage of the peak voltage (V_{P}) (e.g., 85% of the peak voltage (V_{P}), 110% of the peak voltage (V_{P}), etc.), as one or more percentages of one or more other target voltages, as a predetermined amount more than the background voltage (V_{B}) (e.g., 5 V more than the background voltage (V_{B})) as a predetermined amount less than the peak voltage (V_{P}) (e.g.. 5 V less than the peak voltage (V_{P})), as a predetermined amount more than the peak voltage (V_{P}), as one or more predetermined amounts more or less than one or more other target voltages, and/or by otherwise modifying one or more target voltages. In some examples, the anomalous cathode voltage threshold (V_{AC}) is 5-10 volts (e.g., 8 volts) greater than the background voltage (V_{B}).

The control circuitry 112 may monitor a measured voltage relative to either or both of the voltage thresholds (V_{SC}, V_{AC}) to detect a short circuit event. For example, the control circuitry 112 may determine that a short circuit event has occurred based only on an anomalous cathode event indication (e.g., a measured voltage being greater than an anomalous cathode voltage threshold), only a direct short circuit event indication (e.g., a measured voltage being less than a short circuit detection voltage threshold), and/or on any, some, or all of an anomalous cathode event indication, For example, and referring again to FIG. 1, the control circuitry 112 may additionally and/or alternatively determine that a short circuit event has occurred based on, e.g., a power source response short circuit indication, an audio short circuit indication, a spectrographic short circuit indication, and/or one or more other indications.

In some examples, the one or more sensors 160 include the power source sensor 165, which is configured to measure a state and/or parameter of the power source 108 and/or the power conversion circuitry 110 and generate a power source sensor signal comprising a measured power source response. A measured power source response may be used to detect a short circuit event by detecting, e.g., a load change on the power source 108 and/or on the power conversion circuitry 110 (as indicated by, e.g., an inverter of the power conversion circuitry 110), a change in rpm or torque of an engine or motor of the power source 108, and/or one or more other changes and/or indications. In some examples, the control circuitry 112 may monitor a power source sensor signal generated by the power source sensor 165 (e.g., during a background phase of a pulse cycle) to determine whether a short circuit event occurred by detecting a power source response short circuit indication. In some examples, in response to determining that a short circuit event occurred by detecting a power source response short circuit indication, the control circuitry 112 determines one or more short circuit parameters (e.g., a short circuit duration) based on the power source sensor signal, a predetermined short circuit duration (e.g., a predetermined short circuit duration associated with the power source response short circuit indication), and/or on one or more other factors.

In some examples, the one or more sensors 160 include the audio sensor 166 (e.g., a microphone), which is configured to measure audio feedback of the system 100 (e.g., sounds produced by the welding torch 106, a welding arc, the power source 108, the power supply 102, and/or the wire feeder 104) and generate an audio sensor signal comprising a detected audio (e.g., a decibel level, a sound profile, an audio frequency spectrum, etc.). Detected audio may be used to detect a short circuit event by detecting, e.g., a sound signature and/or signature frequency spectrum produced by a short circuit between the electrode 142 and the workpiece 146, a sound signature and/or signature frequency spectrum produced by a load change on the power conversion circuitry 110 and/or the power source 108, and/or one or more other sounds. In some examples, the control circuitry 112 may monitor an audio sensor signal generated by the audio sensor 166 (e.g., during a background phase of a pulse cycle) to determine whether a short circuit event occurred by detecting an audio short circuit indication. In some examples, in response to determining that a short circuit event occurred by detecting an audio short circuit indication, the control circuitry 112 determines one or more short circuit parameters (e.g., a short circuit duration) based on the audio sensor signal, a predetermined short circuit duration (e.g., a predetermined short circuit duration associated with the audio short circuit indication), and/or on one or more other factors.

In some examples, the one or more sensors 160 include the spectrometer 167, which is configured to measure a spectrographic emission (e.g., light) of (e.g., produced) by a welding arc between the electrode 142 and the workpiece 146 and generate a spectrometer signal comprising a measured spectrographic emission. A measured spectrographic emission (e.g., an emitted light spectrum) may be used to detect a short circuit event by detecting, e.g., level(s) and/or frequencies of light indicating that a short circuit has occurred. In some examples, the control circuitry 112 may monitor a spectrometer signal generated by the spectrometer 167 (e.g., during a background phase of a pulse cycle) to determine whether a short circuit event occurred by detecting a spectrographic short circuit indication. In some examples, in response to determining that a short circuit event occurred by detecting a spectrographic short circuit indication, the control circuitry 112 determines one or more short circuit parameters (e.g., a short circuit duration) based on the spectrometer signal, a predetermined short circuit duration (e.g., a predetermined short circuit duration associated with the spectrographic short circuit indication), and/or on one or more other factors.

In response to determining that a short circuit event has occurred, the control circuitry 112 may modify one or more welding parameters based on one or more short circuit parameters of the short circuit event. By modifying one or more welding parameters based on one or more short circuit parameters of a short circuit event, the control circuitry 112 may control and/or maintain one or more aspects of the system 100. For example, the control circuitry 112 may control and/or maintain an arc length of a welding arc by controlling and/or otherwise modifying one or more welding parameters based on one or more short circuit parameters of a short circuit. In some examples, to control and/or maintain the arc length of the welding arc, the control circuitry 112 controls and/or otherwise modifies any, some, or all of one or more wire feed speeds, one or more durations of one or more waveform phases, one or more durations of one or more portions of a waveform, one or more waveform frequencies, one or more ramp up rates, one or more ramp down rates, one or more target voltages, one or more target currents, one or more target powers, one or more target resistances, one or more target enthalpies, one or more other target values, and/or one or more pulse parameters (e.g., one or more pulse widths, one or more pulse frequencies, one or more target peak voltages, one or more target background voltages, one or more target peak currents, one or more target background currents, one or more target peak powers, one or more target background powers, one or more target peak resistances, one or more target background resistances, one or more target peak enthalpies, one or more target background enthalpies, etc.).

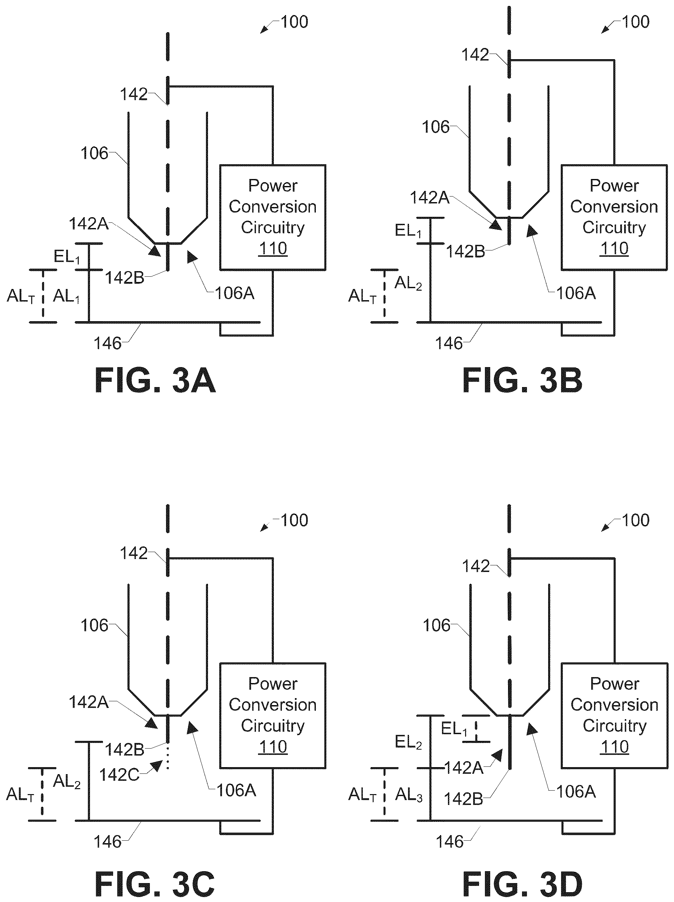

Referring now to FIGS. 3A-3D, and with reference to FIG. 1, an electrode extension 142A of the electrode 142 is a portion of the electrode 142 which extends beyond a contact tip 106A of the welding torch 106. In the example of FIG. 3A, the electrode extension 142A has a first electrode extension length (EL₁) (e.g., a length of the electrode 142 between the contact tip 106A and a tip 142B of the electrode extension 142A). In the example of FIG. 3A, the position of the contact tip 106A relative to the workpiece 146 and the first electrode extension length (EL₁) provide a first arc length (AL₁) (e.g., a distance between the tip 142B of the electrode extension 142A and the workpiece 146) equal to a target arc length (AL_{T}) (e.g., a selected, determined, calculated, ideal, and/or desired value or range of values of arc lengths of the system 100).

In the example of FIG. 3B, however, the contact tip 106A has moved further from the workpiece 146 than in the example of FIG. 3A, while the first electrode extension length (EL₁) remains the same. Accordingly, in the example of FIG. 3B, the position of the contact tip 106A relative to the workpiece 146 and the first electrode extension length (EL₁) provide a second arc length (AL₂) greater than the target arc length (AL_{T}). Because the second arc length (AL₂) is greater than the first arc length (AL₁), durations of short circuit events (e.g., following a pulse phase of a pulse cycle) between the electrode extension 142A and the workpiece 146 generally shorten in duration, as molten metal being transferred from the electrode extension 142A to the workpiece 146 joins each together for shorter periods of time. For example, surface tension of the molten metal can keep the electrode extension 142A and the workpiece 146 connected. However, as the arc length lengthens, the surface tension of the molten metal may become more stressed while connecting the electrode extension 142A and the workpiece 146 and, thereby, reducing an amount of time the electrode extension 142A is connected to the workpiece 146 (e.g., a short circuit duration). Accordingly, shorter short circuit durations can indicate longer arc lengths, and longer short circuit durations can indicate shorter arc lengths. By selecting, determining, or otherwise utilizing a target short circuit duration (e.g., a single value or a range of values) corresponding to a target arc length, measured short circuit durations may be compared to the target short circuit duration as a proxy for measuring arc length.

In the example of FIG. 3C, the control circuitry 112, based on one or more short circuit durations of one or more short circuit events between the electrode extension 142A and the workpiece 146, determines one or more welding parameters configured to elongate the electrode extension 142A by an additional length 142C. For example, by, e.g., decreasing a target peak voltage, decreasing one or more other target voltages, decreasing a target peak current, decreasing one or more other target currents, decreasing a waveform frequency, decreasing a pulse frequency, modifying a duration of a waveform phase, modifying a duration of a portion of a waveform, otherwise modifying one or more portions of a waveform, decreasing a pulse width, decreasing a ramp up rate (e.g., of a peak phase), and/or increasing a ramp down rate (e.g., of a background phase) while maintaining a substantially constant wire feed speed, the length of the electrode extension 142A can be increased by decreasing a rate at which the electrode 142 melts, thereby providing a greater amount of time for the electrode 142 to travel beyond the contact tip 106A prior to melting into the workpiece 146. Conversely, by, e.g., increasing a target peak voltage, increasing one or more other target voltages, increasing a target peak current, increasing one or more other target currents, increasing a waveform frequency, increasing a pulse frequency, modifying a duration of a waveform phase, modifying a duration of a portion of a waveform, otherwise modifying a portion of a waveform, increasing a pulse width, increasing a ramp up rate (e.g., of a peak phase), and/or decreasing a ramp down rate (e.g., of a background phase) while maintaining a substantially constant wire feed speed, the length of the electrode extension 142A can be decreased by increasing a rate at which the electrode 142 melts. Accordingly, by comparing the duration of a measured short circuit duration to a target short circuit duration, the control circuitry 112 can determine that the second arc length (AL₂) is unequal to the target arc length (AL_{T}) and, based on a difference between the measured short circuit duration and target short circuit duration, determine one or more welding parameters to modify to adjust the arc length closer to the target arc length (AL_{T}) and an amount by which each of the one or more welding parameters should be modified.

In the example of FIG. 3D, the control circuitry 112 has modified one or more welding parameters (e.g., by decreasing a pulse width) to slow a rate of melting of the electrode 142. Accordingly, the electrode extension 142A now defines a second electrode extension length (EL₂) longer than the first electrode extension length (EL₁) of FIGS. 3A-3C. By increasing the length of the electrode extension 142A, the tip 142B of the electrode extension 142A and the workpiece 146 now define a third arc length (AL₃) equal to the target arc length (AL_{T}), even though the contact tip 106A is positioned the same distance from the workpiece 146 as in FIGS. 3B and 3C.

Through processes such as those depicted in FIGS. 3A-3D, the control circuitry 112 can control and/or maintain an arc length of a welding arc of the system 100 based on measured short circuit durations of short circuits between the electrode 142 and the workpiece 146. Such processes enable the control circuitry 112 to reduce variations in the arc length of the system 100 even as a distance between the contact tip 106A and the workpiece 146 varies.

In some examples, the target arc length (AL_{T}) and/or one or more other target arc lengths may comprise single value, a range of values, and/or one or more other pluralities of values. For example, a target arc length may be determined by a single value in addition to a difference magnitude threshold (e.g., a percentage of the single value), and the control circuitry 112 may not modify one or more welding parameters even if an arc length is unequal to the single value of the target arc length if the arc length nonetheless differs from the single value by less than the difference magnitude threshold.

In some examples, a control loop controlling one or more welding parameters based on short circuit duration and/or one or more other welding parameters and/or characteristics of a weld circuit may dampen (e.g., bring closer to a target value), filter (e.g., omit outlier values), weight (e.g., apply a 0.8x multiplier, a 1.2x multiplier, etc. to an influence of an input value), and/or otherwise modify one or more input values of the control loop (e.g., a measured short circuit duration, a predetermined short circuit duration, and/or one or more other short circuit parameters for a short circuit duration control loop, a measured voltage for a control loop of a voltage-controlled mode, etc.) and/or one or more output values of the control loop (e.g., one or more amounts to add to, subtract from, multiply by, etc. pulse width, current, and/or one or more welding parameters). Such dampening, filtering, weighting, modification, etc. may improve the performance of a control loop by, e.g., reducing and/or avoiding overshoot, oscillation, and/or one or more other undesirable effects. For example, referring to FIGS. 3A-3D, a short circuit duration control loop that does not incorporate dampening, filtering, weighting, modification, etc. may cause an arc length to iteratively oscillate between being greater than the target arc length (A_{LT}) and being less than the target arc length (A_{LT}) due to repeated overshooting by the control loop, and such oscillation in arc length may worsen weld quality and/or otherwise negatively affect a welding operation.

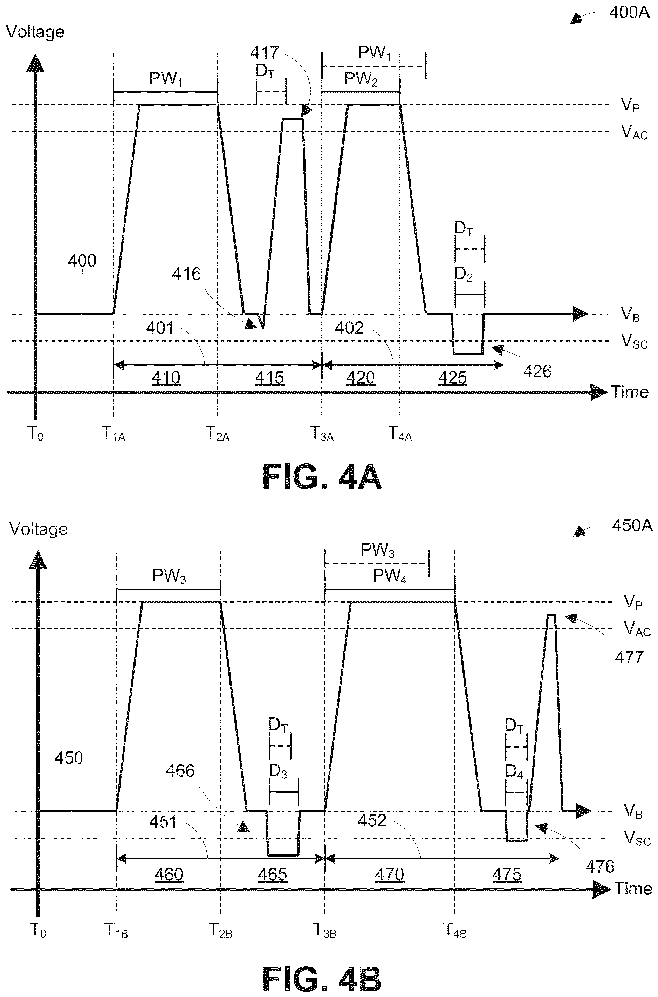

FIGS. 4A and 4B depict separate example processes of modifying one or more welding parameters based on short circuit duration. For example, FIG. 4A depicts a graph (x-axis: time; y-axis: voltage) of an example of a waveform 400A of a voltage 400 of the system 100 (measured by, e.g., the voltage sensor 162) during example pulse cycles. In the waveform 400A, the control circuitry 112 detects a first short circuit event 416 by detecting an anomalous cathode event 417 during a first background phase 415 of a first pulse cycle 401 and determines one or more welding parameters of a second pulse cycle 402 (e.g., a second pulse width (PW₂), a target peak current, and/or a target peak voltage) based on one or more short circuit parameters (e.g., a predetermined short circuit duration) of the first short circuit event 416 and one or more welding parameters (e.g., a first pulse width (PW₁), a target peak current, and/or a target peak voltage) of the first pulse cycle 401.

In the example of FIG. 4A, a first peak phase 410 of the first pulse cycle 401 is defined by the first pulse width (PW₁). During the first background phase 415, the control circuitry 112 does not detect the voltage 400 (e.g., as measured by the voltage sensor 162) as being less than the short circuit detection voltage threshold (V_{SC}). In this example, the control circuitry 112 does, however, detect the voltage 400 (e.g., as measured by the voltage sensor 162) as being greater than the anomalous cathode event voltage threshold (V_{AC}), and the control circuitry 112 thereby determines that an anomalous cathode event 417 occurred. By determining that the anomalous cathode event 417 occurred during the first background phase 415, the control circuitry 112 further determines that the first short circuit event 416 occurred.

In the example of FIG. 4A, the control circuitry 112 associates the first short circuit event 416 with a predetermined short circuit duration, e.g., because the control circuitry 112 detected, during the first background phase 415, the voltage 400 as being greater than the anomalous cathode event voltage threshold (V_{AC}) without also detecting, during the first background phase 415, the voltage 400 as being less than the short circuit detection voltage threshold (V_{SC}). The control circuitry 112 then compares the predetermined short circuit duration to a target short circuit duration (D_{T}). In some examples, the predetermined short circuit duration is less than or equal to the target short circuit duration (D_{T}). In some examples, the predetermined short circuit duration is greater than or equal to the target short circuit duration (D_{T}). In some examples, the predetermined short circuit duration may be very small (e.g., less than or equal to 1 millisecond, less than or equal to 0.5 milliseconds, less than or equal to 0.3 milliseconds, or even less than or equal to 0.1 milliseconds). In the example of FIG. 4A, the predetermined short circuit duration is less than the target short circuit duration (D_{T}). Accordingly, the control circuitry 112 determines the second pulse width (PW₂) based on the first pulse width (PW₁) and the predetermined short circuit duration, e.g., by decreasing the first pulse width (PW₁) by an amount proportional to a difference between the predetermined short circuit duration and the target short circuit duration (D_{T}).

In some examples, the control circuitry 112 additionally and/or alternatively decreases and/or otherwise modifies (e.g., by decreasing one or more parameters and increasing one or more other parameters) any, some, or all of the first pulse width (PW₁), one or more other pulse widths, the peak voltage (V_{P}), the background voltage (V_{B}), one or more other target voltages, one or more pulse frequencies, one or more durations of one or more waveform phases, one or more durations of one or more portions of a waveform, one or more waveform frequencies, one or more target peak currents, one or more target background currents, one or more other target currents, one or more ramp up rates (e.g., from V_{B} to V_{P}, etc.), one or more ramp down rates (e.g., from V_{P} to V_{B}), one or more target powers (e.g., a background power and/or a peak power), one or more target resistances (e.g., a background resistance and/or a peak resistance), one or more target enthalpies (e.g., a background enthalpy and/or a peak enthalpy), one or more other target values, and/or one or more other pulse parameters based on a difference between the predetermined short circuit duration and the target short circuit duration (D_{T}). The control circuitry 112 then controls the power conversion circuitry 110 to output welding power according to the second pulse cycle 402, which includes a second peak phase 420 defined by the second pulse width (PW₂).

In the example of FIG. 4A, because the second pulse width (PW₂) is less than the first pulse width (PW₁), a second short circuit event 426 has a second short circuit duration (D₂) substantially equal to and/or within a range of the target short circuit duration (D_{T}). In the example of FIG. 4A, the control circuitry 112 determines that the second short circuit event 426 has occurred by detecting that the voltage 400 is less than the short circuit detection voltage threshold (V_{SC}) during a second background phase 425 of the second pulse cycle 402. The control circuitry 112 determines the second short circuit duration (D₂) (e.g., based on the voltage 400) and compares the second short circuit duration (D₂) to the target short circuit duration (D_{T}). By determining that the second short circuit duration (D₂) is equal to and/or within a range of the target short circuit duration, the control circuitry 112 may determine that one or more welding parameters can be maintained.

FIG. 4B depicts a graph (x-axis: time; y-axis: voltage) of an example of a waveform 450B of a voltage 450 of the system 100 (measured by, e.g., the voltage sensor 162) during example pulse cycles. In the waveform 450B, the control circuitry 112 detects a third short circuit event 466 by determining that determining that the voltage 450 is less than the short circuit detection voltage threshold (V_{SC}) during a third background phase 465 of a third pulse cycle 451 and determines one or more welding parameters of a fourth pulse cycle 452 (e.g., a fourth pulse width (PW₄), a target peak current, and/or a target peak voltage) based on one or more short circuit parameters (e.g., a predetermined short circuit duration) of the third short circuit event 466 and one or more welding parameters (e.g., a first pulse width (PW₃), a target peak current, and/or a target peak voltage) of the first pulse cycle 401.

In the example of FIG. 4B, a third peak phase 460 of the third pulse cycle 451 is defined by the third pulse width (PW₃). During the third background phase 465, the control circuitry 112 detects the voltage 450 (e.g., as measured by the voltage sensor 162) as being less than the short circuit detection voltage threshold (V_{SC}), and the control circuitry 112 thereby determines that the third short circuit event 466 occurred. In the example of FIG. 4B, the control circuitry 112 determines a third short circuit duration (D₃) of the third short circuit event 466. The control circuitry 112 then compares the third short circuit duration (D₃) to a target short circuit duration (D_{T}). In the example of FIG. 4B, the third short circuit duration (D₃) is greater than the target short circuit duration (D_{T}). Accordingly, the control circuitry 112 determines the fourth pulse width (PW₄) based on the third pulse width (PW₃) and the third short circuit duration (D₃), e.g., by increasing the third pulse width (PW₃) by an amount proportional to a difference between the third short circuit duration (D₃) and the target short circuit duration (D_{T}). In some examples, the control circuitry 112 additionally and/or alternatively increases, decreases, and/or otherwise modifies (e.g., by increasing one or more parameters and decreasing one or more other parameters), based on to a difference between the third short circuit duration (D₃) and the target short circuit duration (D_{T}), any, some, or all of the third pulse width (PW₃), one or more other pulse widths, one or more pulse frequencies, the peak voltage (V_{P}), the background voltage (V_{B}), one or more other target voltages, a target peak current, a target background current, one or more other target currents, one or more wire feed speeds, one or more ramp up rates, one or more ramp down rates, one or more durations of one or more waveform phases, one or more durations of one or more portions of a waveform, one or more waveform frequencies, one or more target powers, one or more target resistances, one or more target enthalpies, and/or one or more other welding parameters. The control circuitry 112 then controls the power conversion circuitry 110 to output welding power according to the fourth pulse cycle 452, which includes a fourth peak phase 470 defined by the fourth pulse width (PW₄).

In the example of FIG. 4B, because the fourth pulse width (PW₄) is greater than the third pulse width (PW₃), a fourth short circuit event 476 has a fourth short circuit duration (D₄) substantially equal to and/or within a range of the target short circuit duration (D_{T}). In the example of FIG. 4B, the control circuitry 112 determines that the fourth short circuit event 476 has occurred by detecting that the voltage 450 is less than the short circuit detection voltage threshold (V_{SC}) during a fourth background phase 475 of the fourth pulse cycle 452. The control circuitry also determines that an anomalous cathode event 477 has occurred by detecting that the voltage 450 is greater than the anomalous cathode voltage threshold (V_{AC}) during the fourth background phase 475. However, in the example of FIG. 4B, because the control circuitry 112 also determined that the fourth short circuit event 476 occurred based on the voltage 450 being less than the short circuit detection voltage (V_{SC}), the control circuitry 112 does not associate a predetermined short circuit duration with the fourth short circuit event 476. Rather, the control circuitry 112 determines the fourth short circuit duration (D₄) (e.g., based on the voltage 450) and compares the fourth short circuit duration (D₄) to the target short circuit duration (D_{T}). By determining that the fourth short circuit duration (D₄) is equal to and/or within a range of the target short circuit duration, the control circuitry 112 may determine that one or more welding parameters can be maintained.

The waveforms 400A, 450B are depicted in FIG. 4A and/or FIG. 4B as including substantially constant values and substantially constant rates of change during some time intervals, but such depictions are for illustrative purposes only. In some examples, a current and/or voltage (e.g., measured by either or both of the sensors 162, 164) may vary during one or more time intervals in one or more ways not depicted in and/or indicated by FIG. 4A and/or FIG. 4B. For example, relative proportions of voltage levels (e.g., target peak voltages, target background voltages, voltage levels of short circuits, voltage levels of anomalous cathode events, etc.), voltage rates of change (e.g. one or more ramp up rates, one or more ramp down rates, one or more rates of change to or from voltage levels of a short circuit, one or more rates of change to or from voltage levels of an anomalous cathode event, etc.), or durations (e.g., durations of one or more peak phases, durations of one or more background phases, durations of one or more short circuits, durations of one or more anomalous cathode events, etc.) depicted in FIG. 4A and/or FIG. 4B are purely illustrative and may, in various embodiments, vary from the relative proportions depicted in FIG. 4A and/or FIG. 4B.

In some examples, the target short circuit duration (D_{T}) and/or one or more other target welding parameters and/or target short circuit parameters may comprise single value, a range of values, and/or one or more other pluralities of values. For example, a target short circuit duration may be determined by a single value (e.g., 0.5 milliseconds) in addition to a difference magnitude threshold (e.g., a percentage of the single value), and the control circuitry 112 may not modify one or more welding parameters even if a measured short circuit duration is unequal to the single value of the target short circuit duration if the measured short circuit duration nonetheless differs from the single value by less than the difference magnitude threshold.

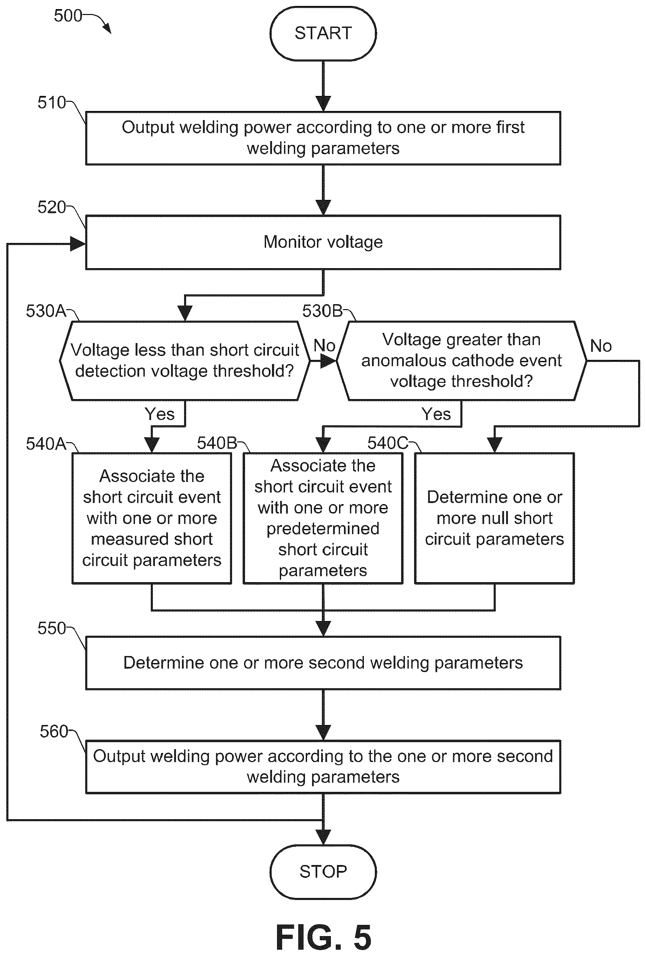

FIG. 5 is a flowchart illustrating an example of a process 500 of operating a welding system (e.g., the system 100). The process 500 may be implemented by control circuitry (e.g., the control circuitry 112) by executing machine-readable instructions, e.g., stored on a non-transitory machine-readable storage device (e.g., the storage device 123 and/or the memory device 124). In describing the process 500, reference will be made to the examples of FIGS. 1, 2, 4A, and 4B. However, the process 500 may be used with other examples, such as alternative examples described elsewhere herein. In some examples, any, some, or all of the blocks of the process 500 may be performed in alternative orders than those depicted in FIG. 5, repeated any plurality of instances, and/or omitted.

At a block 510 of the process 500, the control circuitry 112 controls the power conversion circuitry 110 to output welding power (e.g., as one or more pulse cycles) according to one or more first welding parameters (e.g., one or more wire feed speeds, one or more durations of one or more waveform phases, one or more durations of one or more other portions of a waveform, one or more waveform frequencies, one or more ramp up rates, one or more ramp down rates, one or more target pulse parameters, one or more target voltages, one or more target currents, one or more target powers, one or more target enthalpies, one or more target resistances, one or more other target welding parameters, one or more pulse parameter setpoints, one or more voltage setpoints, one or more current setpoints, one or more power setpoints, one or more enthalpy setpoints, one or more resistance setpoints, and/or one or more other welding parameter setpoints). In some examples, the control circuitry 112 controls the power conversion circuitry 110 to output one or more first pulse cycles (e.g., any, some, or all of the pulse cycles 201, 401, 451) according to one or more first pulse widths (e.g., any, some, or all of the pulse widths (PW, PW₁, PW₃), one or more other pulse widths, one or more pulse frequencies, one or more ramp up rates, one or more ramp down rates, one or more target peak voltages, one or more target background voltages, one or more other target voltages, one or more target peak currents, one or more target background currents, one or more other target currents, one or more target powers, one or more target enthalpies, one or more target resistances, and/or one or more other target values).

At a block 520 of the process 500, the control circuitry 112 monitors a voltage (e.g., any, some, or all of the voltages 200, 400, 450, a measured voltage, and/or a determined voltage) based on a sensor signal (e.g., generated by either or both of the sensors 162, 164). In some examples, the control circuitry 112 monitors the measured voltage during a background phase (e.g., any, some, or all of the background phases 215, 225, 415, 425, 465, 475) of the one or more pulse cycles. In some examples, the control circuitry 112 additionally and/or alternatively monitors one or more other welding parameters of the system 100, such as one or more measured welding parameters (e.g., a measured current measured by the current sensor 164), one or more determined welding parameters (e.g., a determined voltage calculated based on a measured current measured by the current sensor 164), one or more parameters of welding power output by the power conversion circuitry 110 (e.g., an output current), one or more measured power source responses (e.g., based on a sensor signal generated by the power source sensor 165), one or more detected audios (e.g., based on a sensor signal generated by the audio sensor 166), one or more measured spectrographic emissions (e.g., based on a sensor signal generated by the spectrometer 167), and/or one or more other welding parameters.

At a block 530A of the process 500, the control circuitry 112, while monitoring the voltage, determines whether the voltage (e.g., any, some, or all of the voltages 200, 400, 450, a measured voltage, and/or a determined voltage) is less than a short circuit detection voltage threshold (e.g., the short circuit detection voltage threshold (V_{SC}) of any, some, or all of FIGS. 2, 4A, and 4B) to determine whether a short circuit event has occurred (e.g., any, some, or all of the short circuit events 216, 226, 416, 426, 466, 476). In some examples, to determine whether a short circuit event has occurred, the control circuitry 112 additionally and/or alternatively compares one or more other welding parameters (e.g., one or more measured currents, one or more determined voltages, one or more output currents, one or more measured power source responses, one or more detected audios, and/or one or more measured spectrographic emissions) to one or more other thresholds (e.g., a short circuit detection voltage threshold, a short circuit detection current threshold, a short circuit detection power source response threshold, a short circuit detection audio threshold, and/or a short circuit detection spectrographic threshold). In some examples, the process 500 may omit the block 530A.

At a block 540A of the process 500, if the control circuitry 112 determined that the short circuit event occurred in the block 530A (e.g., any, some, or all of the short circuit events 216, 426, 466, 476), the control circuitry 112 associates the short circuit event with one or more measured short circuit parameters (e.g., any, some, or all of the short circuit durations (D_{S}, D₂, D₃, D₄), the voltage 400, the voltage 450, a measured short circuit duration, a measured short circuit voltage, and/or a measured short circuit current). In some examples, the control circuitry 112, at the block 540A, additionally and/or alternatively associates the short circuit event with one or more predetermined short circuit parameters (e.g., a predetermined short circuit duration, a predetermined short circuit voltage, and/or a predetermined short circuit current) and/or one or more determined short circuit parameters (e.g., a determined short circuit duration, a determine short circuit voltage, and/or a determined short circuit current) determined by, e.g., the control circuitry 112 based on, e.g., one or more sensor signals generated by any, some, or all of the sensors 160, 162, 164, 165, 166, 167. The control circuitry 112 may measure and/or determine one or more short circuit parameters based on one or more sensor signals generated by any, some, or all of the sensors 160, 162, 164, 165, 166, 167. In some examples, the process 500 may omit the block 540A.

At a block 530B of the process 500, if the control circuitry 112 did not determine that the short circuit event occurred in the block 530A, the control circuitry 112, while monitoring the voltage, determines whether the voltage (e.g., any, some, or all of the voltages 200, 400, 450, a measured voltage, and/or a determined voltage) is greater than an anomalous cathode event threshold (e.g., the anomalous cathode event threshold (V_{AC}) of any, some, or all of FIGS. 2, 4A, and 4B) to determine whether an anomalous cathode event (e.g., any, some, or all of the anomalous cathode events 227, 417, 477) has occurred. In some examples, to determine whether an anomalous event has occurred, the control circuitry 112 additionally and/or alternatively compares one or more other measured and/or determined parameters (e.g., a measured voltage, a measured current, a determined voltage, and/or a determined current) to one or more other thresholds (e.g., an anomalous cathode event voltage threshold and/or an anomalous cathode event current threshold). In some examples, the process 500 may omit the block 530B.

At a block 540B of the process 500, if the control circuitry 112 determined that the anomalous cathode event occurred in the block 530B (e.g., any, some, or all of the anomalous cathode events 227, 417, 477), the control circuitry 112 thereby determines that a short circuit event occurred and associates the short circuit event with one or more predetermined short circuit parameters (e.g., a predetermined short circuit duration, a predetermined short circuit voltage, and/or a predetermined short circuit current). In some examples, the control circuitry 112, at the block 540B, additionally and/or alternatively associates the anomalous cathode event with one or more measured parameters and/or one or more determined parameters determined by, e.g., the control circuitry 112 based on, e.g., one or more sensor signals generated by any, some, or all of the sensors 160, 162, 164, 165, 166, 167. In some examples, the process 500 may omit the block 540B.

At a block 540C of the process 500, if the control circuitry 112 did not determine that the anomalous cathode event occurred in the block 530B, the control circuitry 112 determines one or more null short circuit parameters. In some examples, a null short circuit parameter is a predetermined short circuit parameter (e.g., a predetermined short circuit duration, a predetermined voltage, and/or a predetermined current). In some examples, a null short circuit parameter includes one or more values associated with no occurrence of a short circuit (e.g., a short circuit duration of 0 seconds). In some examples, the process 500 may omit the block 540C. For example, if the control circuitry 112 did not determine that the anomalous cathode event occurred in the block 530B, then the process 500 may return to the block 510 and/or the block 520. In some examples, the process 500 may omit any, some, or all of the blocks 530A, 540A, 540C.

At a block 550 of the process 500, the control circuitry 112 determines one or more second welding parameters (e.g., one or more durations of one or more waveform phases, one or more durations of one or more portions of a waveform, one or more waveform frequencies, one or more pulse parameters, one or more wire feed speeds, one or more ramp up rates, one or more ramp down rates, one or more target voltages, one or more target currents, one or more target powers, one or more target resistances, one or more target enthalpies, and/or one or more other target welding parameters). In some examples, the control circuitry 112 determines one or more pulse parameters (e.g., any, some, or all of the pulse widths (PW, PW₂, PW₄), one or more other pulse widths, one or more pulse frequencies, one or more ramp up rates, one or more ramp down rates, one or more target peak voltages, one or more target background voltages, one or more other target voltages, one or more target peak currents, one or more target background currents, one or more other target currents, one or more target powers, one or more target enthalpies, one or more target resistances, and/or one or more other target pulse parameters). The control circuitry 112 may determine the one or more second welding parameters based on the one or more first welding parameters of the block 510 (e.g., by modifying one or more of the one or more first welding parameters of the block 510), one or more measured short circuit parameters (e.g., one or more of the one or more measured short circuit parameters of the block 540A), one or more determined short circuit parameters (e.g., one or more of the one or more determined short circuit parameters of the block 540A), one or more predetermined short circuit parameters (e.g., one or more of the one or more predetermined short circuit parameters of the block 540B and/or one or more of the null short circuit parameters of the block 540C), one or more target short circuit parameters (e.g., a target short circuit duration, a target short circuit voltage, and/or a target short circuit current), and/or one or more other parameters. For example, the control circuitry 112 may compare a measured short circuit duration (e.g., associated with the short circuit event in the block 540A), a predetermined short circuit duration (e.g., associated with the short circuit event in the block 540B), or a null short circuit duration (e.g., determined in the block 540C) with a target short circuit duration and, in response to determining a difference between the target short circuit duration and the measured short circuit duration, predetermined short circuit duration, or null short circuit duration, modify a pulse width, a pulse frequency, a target peak voltage, and/or a target peak current of the one or more first welding parameters based on the difference. In some examples, some or all of the one or more second welding parameters are equal to some or all of respective ones of the one or more first welding parameters. For example, the control circuitry 112 may, in response to determining that a measured short circuit duration (e.g., associated with the short circuit event in the block 540A) is equal to and/or within a range of a target short circuit duration, use the one or more first welding parameters of the block 510 as the one or more second welding parameters (e.g., leave the one or more first welding parameters unchanged).

At a block 560 of the process 500, the control circuitry 112 controls the power conversion circuitry 110 to output welding power according to the one or more second welding parameters of the block 550 (e.g., one or more durations of one or more waveform phases, one or more durations of one or more portions of a waveform, one or more waveform frequencies, one or more pulse parameters, one or more ramp up rates, one or more ramp down rates, one or more wire feed speeds, one or more target voltages, one or more target currents, one or more target powers, one or more target resistances, one or more target enthalpies, and/or one or more other target welding parameters). In some examples, the control circuitry 112 controls the power conversion circuitry 110 to output one or more second pulse cycles (e.g., any, some, or all of the pulse cycles 202, 402, 452) according to the one or more second pulse parameters of the block 550 (e.g., any, some, or all of the pulse widths (PW, PW₂, PW₄), one or more other pulse widths, one or more pulse frequencies, one or more ramp up rates, one or more ramp down rates, one or more target peak voltages, one or more target background voltages, one or more other target voltages, one or more target peak currents, one or more target background currents, one or more other target currents, one or more target powers, one or more target enthalpies, one or more target resistances, and/or one or more other target pulse parameters).

In some examples, after the block 560, the process 500 returns to the block 520 (e.g., immediately, during a subsequent pulse cycle, after one pulse cycle, after a predetermined number of pulse cycles, and/or after a predetermined amount of time) to continue the process 500 during a welding operation. In some examples, any, some, or all of the blocks 520, 530A, 530B, 540A, 540B, 540C, 550, 560 may be reiterated, with welding parameters being modified and/or remaining unchanged in each iteration of the block 550. In some examples, after the block 560, the process 500 may end, e.g., due to a welding operation ending.

In some examples, if the control circuitry 112 did not determine that the short circuit event occurred in the block 530A, the process 500 may not progress to the block 530B, and, in some such examples, the process 500 may instead proceed from the block 530A to the block 520 (e.g., reiterate the block 520), to the block 540C (e.g., omit the blocks 530B, 540B), to any, some, or all of the blocks 510, 520, 550, 560 (e.g., omit the blocks 530B, 540B, 540C), end, and/or otherwise differ from the example of the process 500 depicted in FIG. 5. In some examples, the process 500 may omit either or both of the blocks 530A, 540A, and, in some such examples, the process 500 may instead proceed from the block 520 to the block 530B and/or otherwise differ from the example of the process 500 depicted in FIG. 5. In some examples, if the control circuitry 112 did not determine that the anomalous cathode event occurred in the block 530B, the process 500 may not progress to the block 540C, and, in some such examples, the process 500 may instead proceed from the block 530B to the block 510 (e.g., reiterate the block 510), to the block 520 (e.g., reiterate the block 520), to the block 530A (e.g., reiterate the block 530A), to either or both of the blocks 550, 560 (e.g., omit the block 540C), end, and/or otherwise differ from the example of the process 500 depicted in FIG. 5.

As used herein, the term "welding operation" refers to a process of welding one or more materials, components, etc. using one or more welding modes.

As used herein, the terms "welding system" and "welding-type system" refer to systems capable of generating and/or conditioning welding power and/or of conducting a welding operation (e.g., by generating, conditioning, and/or receiving welding power). A welding system or welding-type system may operate and/or be capable of operating in only one welding mode and/or in any plurality of welding modes.

As used herein, the terms "torch," "welding torch," "welding tool," and "welding-type tool" can include a hand-held or robotic welding torch, gun, or other device used to create the welding arc.

As used herein, the term "electrode" includes any consumable or non-consumable material which may be controllably provided to a welding torch by welding equipment and which may conduct a weld current (e.g., welding wire).

As used herein, the term "processor" means processing devices, apparatus, programs, circuits, components, systems, and subsystems, whether implemented in hardware, tangibly embodied software, or both, and whether or not it is programmable. The term "processor" as used herein includes, but is not limited to, one or more computing devices, hardwired circuits, signal-modifying devices and systems, devices and machines for controlling systems, central processing units, programmable devices and systems, field-programmable gate arrays, application-specific integrated circuits, systems on a chip, systems comprising discrete elements and/or circuits, state machines, virtual machines, data processors, processing facilities, and combinations of any of the foregoing. The processor may be, for example, any type of general-purpose microprocessor or microcontroller, a digital signal processing ("DSP") processor, an application-specific integrated circuit ("ASIC"), a graphic processing unit ("GPU"), a reduced instruction set computer ("RISC") processor with an advanced RISC machine ("ARM") core, etc. The processor may be coupled to, and/or integrated with a memory storage device.

As utilized herein the terms "circuits," "circuitry," "controller," and "control circuitry" refer to physical electronic components (i.e., hardware) and any software and/or firmware ("code") which may configure the hardware, be executed by the hardware, and/or otherwise be associated with the hardware. As used herein, for example, a "circuit" may comprise any analog and/or digital components, power and/or control elements (such as a microprocessor, digital signal processor ("DSP"), software, and the like), discrete and/or integrated components, associated software, hardware, and/or firmware, and/or portions and/or combinations thereof. As used herein, for example, a particular processor and memory storage device may comprise a first "circuit" when executing a first set of one or more lines of code and may comprise a second "circuit" when executing a second set of one or more lines of code. As utilized herein, circuitry is "operable" to, "configurable to," and/or "configured to" perform a function whenever the circuitry comprises the necessary hardware and code (if any is necessary) to perform the function, regardless of whether performance of the function is disabled or not enabled (for example, by an operator-configurable setting, factory trim, etc.).

As used herein, the term "communication circuitry" refers to physical electronic components (i.e., hardware) and, in some examples, any software and/or firmware (i.e., code) which may configure the hardware, be executed by the hardware, and/or otherwise enable the hardware to communicate with one or more other devices (e.g., with communication circuitry of such one or more other devices). Communication circuitry may include hardware capable of wired and/or wireless communication with one or more other devices. Hardware capable of wired communication may include, e.g., one or more cables or other optical communication mechanisms, one or more computer buses, and/or one or more additional wired mechanisms for communicating with one or more communications networks and/or one or more devices. Hardware capable of wireless communications may include, e.g., one or more transceivers, one or more antennas, one or more modems, one or more local area network ("LAN") ports, one or more wireless fidelity ("Wi-Fi") cards, one or more WiMax cards, mobile communications hardware, near-field communication hardware, satellite communication hardware, hardware configured to communicate in accordance with one or more wireless communication protocols (e.g., IrDA, Bluetooth, Wireless USB, Z-Wave, ZigBee, radio frequency identification ("RFID"), one or more other near field communications ("NFC") protocols, and/or one or more other protocols for close-proximity and/or wireless communication), and/or other hardware for wirelessly communicating with one or more communications networks and/or one or more devices. Communication circuitry may include one or more network interfaces, one or more input-output ("I/O") interfaces, and/or one or more other interfaces for communicating data (e.g., directly, via one or more communications paths, etc.) to and/or from one or more communications networks. An example network interface may include hardware, firmware, and/or software to communicatively couple communication circuitry to one or more communications networks. A network interface may include and/or be coupled to one or more communication paths. A communication path includes hardware which provides signal interconnectivity between one or more components (e.g., control circuitry and a transceiver). A network interface may include any hardware for transmitting and/or receiving communications (e.g., IEEE 802.X-compliant wireless and/or wired communications hardware). An example I/O interface includes hardware, firmware, and/or software to connect one or more I/O devices to control circuitry (communicatively coupled to, e.g., communication circuitry comprising the I/O interface) for providing input to the control circuitry and/or providing output from the control circuitry. For example, the I/O interface may include a graphics processing unit for interfacing with a display device, a universal serial bus port for interfacing with one or more USB-compliant devices, a FireWire, a field bus, and/or any other type of interface. Example I/O device(s) may include a keyboard, a keypad, a mouse, a trackball, a pointing device, a microphone, an audio speaker, a display device, an optical media drive, a multi-touch touch screen, a gesture recognition interface, a magnetic media drive, and/or any other type of input and/or output device. Control circuitry communicatively coupled to an I/O interface may access a non-transitory machine-readable medium via the I/O interface and/or one or more I/O device(s). Examples of a machine-readable medium include optical discs (e.g., compact discs ("CDs"), digital versatile/video discs ("DVDs"), Blu-ray discs, etc.), magnetic media (e.g., floppy disks), portable storage media (e.g., portable flash drives, secure digital ("SD") cards, etc.), and/or any other type of removable and/or installed machine-readable media.

A "communications network" may include one or more of the Internet, one or more personal area networks ("PAN(s)"), one or more LANs, one or more wide area networks ("WAN(s)"), one or more cellular networks, one or more satellite networks, one or more global positioning systems, one or more other such networks, and/or any combination thereof. A LAN may include, e.g., one or more wired technologies (e.g., Ethernet, USB, etc.) and/or one or more wireless technologies (e.g., Wi-Fi). A PAN may include one or more wired technologies (e.g., USB, FireWire, and/or one or more other computer buses) and/or one or more wireless technologies (e.g., Bluetooth, Wireless USB, IrDA, Z-Wave, ZigBee, RFID, one or more other NFC protocols, and/or one or more other protocols for close-proximity and/or wireless communication). A cellular network may include, e.g., technologies such as LTE, WiMAX, UMTS, CDMA, GSM, 3G, 4G, 5G, 6G, and/or one or more other technologies.

As used, herein, the term "memory," "memory storage device," "storage device," and/or "memory device" means computer hardware or circuitry to store information for use by a processor and/or other digital device. The memory, memory storage device, and/or memory device can be any suitable type of computer memory or any other type of electronic storage medium, such as, for example, read-only memory ("ROM"), random access memory ("RAM"), cache memory, compact disc read-only memory ("CDROM"), electro-optical memory, magneto-optical memory, programmable read-only memory ("PROM"), erasable programmable read-only memory ("EPROM"), electrically-erasable programmable read-only memory ("EEPROM"), a computer-readable medium, or the like. Memory can include, for example, a non-transitory memory, a non-transitory processor readable medium, a non-transitory computer readable medium, non-volatile memory, dynamic RAM ("DRAM"), volatile memory, ferroelectric RAM ("FRAM"), first-in-first-out ("FIFO") memory, last-in-first-out ("LIFO") memory, stack memory, non-volatile RAM ("NVRAM"), static RAM ("SRAM"), a cache, a buffer, a semiconductor memory, a magnetic memory, an optical memory, a flash memory, a flash card, a compact flash card, memory cards, secure digital memory cards, a microcard, a minicard, an expansion card, a smart card, a memory stick, a multimedia card, a picture card, flash storage, a subscriber identity module ("SIM") card, a hard drive ("HDD"), a solid state drive ("SSD"), etc. The memory, memory storage device, and/or memory device can be configured to store code, instructions, applications, software, firmware, and/or data, and may be external, internal, or both with respect to a processor.

Features described herein make reference to the accompanying drawings in which exemplary embodiments of the disclosure are shown. However, it should be understood that the systems of this disclosure can be embodied in many different forms and should not be construed as limited to the embodiments set forth herein.

It is to be understood that, as used herein the terms "the," "a," or "an," mean "at least one," and should not be limited to "only one" unless explicitly indicated to the contrary. Thus, for example, reference to "a component" includes embodiments having two or more such components unless the context clearly indicates otherwise.

Unless otherwise expressly stated, it is in no way intended than any method set forth herein be construed as requiring that its steps be performed in a specific order. Accordingly, where a method claim does not actually recite an order to be followed by its steps or it is not otherwise specifically stated in the claims or descriptions that the steps are to be limited to a specific order, it is no way intended that any particular order be inferred.

As utilized herein, "and/or" means any one or more of the items in the list joined by "and/or". As an example, "x and/or y" means any element of the three-element set {(x), (y), (x, y)}. In other words, "x and/or y" means "one or both of x and y". As another example, "x, y, and/or z" means any element of the seven-element set {(x), (y), (z), (x, y), (x, z), (y, z), (x, y, z)}. In other words, "x, y and/or z" means "one or more of x, y and z".

As used herein, the word "exemplary" means serving as a non-limiting example, instance, or illustration. The embodiments described herein are not limiting, but rather are exemplary only. It should be understood that the described embodiments are not necessarily to be construed as preferred or advantageous over other embodiments. Moreover, the terms "embodiments of the invention," "embodiments," or "invention" do not require that all embodiments of the invention include the discussed feature, advantage, or mode of operation. As utilized herein, the terms "e.g." and "for example" set off lists of one or more non-limiting examples, instances, or illustrations.

While the present method, apparatus, and/or system has been described with reference to certain implementations, it will be understood by those skilled in the art that various changes, modifications, and variations may be made to the present disclosure and equivalents may be substituted without departing from the scope of the present disclosure. In addition, many modifications may be made to adapt a particular situation or material to the teachings of the present disclosure without departing from its scope. For example, systems, blocks, and/or other components of disclosed examples may be combined, divided, re-arranged, and/or otherwise modified. Therefore, the present method and/or system are not limited to the particular implementations disclosed. Instead, the present method and/or system will include all implementations falling within the scope of the appended claims, both literally and under the doctrine of equivalents.
Certain embodiments of the invention are described in the following clauses:
Clause 1 A welding system comprising:
   power conversion circuitry configured to convert input power to welding power and to output the welding power to a weld circuit;
   a voltage sensor configured to measure a voltage of the weld circuit and generate a voltage sensor signal comprising a measured voltage; and
   control circuitry configured to:
      control the power conversion circuitry to output the welding power according to one or more first pulse cycles having one or more first pulse parameters;
      monitor the voltage sensor signal during a background phase of the one or more first pulse cycles to determine whether a short circuit event occurred in the weld circuit by detecting that the measured voltage is greater than an anomalous cathode event voltage threshold;
      in response to determining that the short circuit event occurred, determine one or more second pulse parameters based on the one or more first pulse parameters and one or more short circuit parameters of the short circuit event; and
      control the power conversion circuitry to output the welding power according to one or more second pulse cycles having the one or more second pulse parameters.
Clause 2.The welding system of clause 1, wherein the anomalous cathode event voltage threshold is greater than a target background voltage of the one or more first pulse parameters.
Clause 3.The welding system of clause 1, wherein at least one of the one or more second pulse parameters are configured to maintain an arc length of a welding arc of the weld circuit based on the one or more short circuit parameters and on a target arc length.
Clause 4.The welding system of clause 1, wherein:
   the control circuitry is further configured to compare the one or more short circuit parameters to one or more target short circuit parameters to determine one or more short circuit parameter target differences; and
   the determining of the one or more second pulse parameters is based on the one or more first pulse parameters and the one or more short circuit parameter target differences.
Clause 5.The welding system of clause 4, wherein the determining of the one or more second pulse parameters further comprises:
   in response to determining that a magnitude of at least one of the one or more short circuit parameter target differences is greater than a short circuit parameter target difference magnitude threshold, modifying at least one of the one or more first pulse parameters based on the magnitude of the at least one of the one or more short circuit parameter target differences; and
   in response to determining that the magnitude of at least one of the one or more short circuit parameter target differences is not greater than the short circuit parameter target difference magnitude threshold, maintaining the one or more first pulse parameters as the one or more second pulse parameters.
Clause 6.The welding system of clause 1, wherein:
   the one or more first pulse parameters comprise a first pulse width; and
   the one or more second pulse parameters comprise a second pulse width.
Clause 7.The welding system of clause 1, wherein:
   the one or more first pulse parameters comprise at least one of a first pulse width, a first pulse frequency, a first wire feed speed, a first ramp up rate, a first ramp down rate, a first target peak voltage, a first target peak current, a first target background voltage, a first target background current, a first target power, a first target resistance, or a first target enthalpy; and
   the one or more second pulse parameters comprise at least one of a second pulse width, a second pulse frequency, a second wire feed speed, a second ramp up rate, a second ramp down rate, a second target peak voltage, a second target peak current, a second target background voltage, a second target background current, a second target power, a second target resistance, or a second target enthalpy.
Clause 8.The welding system of clause 1, wherein the one or more short circuit parameters comprise at least one of a measured short circuit duration, a predetermined short circuit duration, a measured short circuit voltage, a measured average short circuit voltage, a predetermined short circuit voltage, a measured short circuit current, a measured average short circuit current, or a predetermined short circuit current.
Clause 9.The welding system of clause 1, wherein the control circuitry is further configured to, in response to determining that the short circuit event occurred by detecting that the measured voltage is greater than the anomalous cathode event voltage threshold during the background phase, associate the short circuit event with one or more predetermined short circuit parameters associated with an anomalous cathode event and determine the one or more second pulse parameters based on the one or more predetermined short circuit parameters.
Clause 10.The welding system of clause 9, wherein:
   the one or more predetermined short circuit parameters comprise a predetermined short circuit duration;
   the one or more first pulse parameters comprise a first pulse width;
   the one or more second pulse parameters comprise a second pulse width; and
   the control circuitry is further configured to, in response to determining that the predetermined short circuit duration is greater than a target short circuit duration, determine the second pulse width by increasing the first pulse width based on a difference between the predetermined short circuit duration and the target short circuit duration.
Clause 11.The welding system of clause 9, wherein:
   the one or more predetermined short circuit parameters comprise a predetermined short circuit duration;
   the one or more first pulse parameters comprise a first pulse width;
   the one or more second pulse parameters comprise a second pulse width; and
   the control circuitry is further configured to, in response to determining that the predetermined short circuit duration is less than a target short circuit duration, determine the second pulse width by decreasing the first pulse width based on a difference between the predetermined short circuit duration and the target short circuit duration.
Clause 12.The welding system of clause 10, wherein the control circuitry is further configured to determine the predetermined short circuit duration based on a sampling rate of the voltage sensor.
Clause 13.The welding system of clause 1, wherein the control circuitry is further configured to monitor the voltage sensor signal during the background phase to determine whether the short circuit event occurred in the weld circuit by detecting that the measured voltage is less than a short circuit detection voltage threshold.
Clause 14.The welding system of clause 13, wherein the short circuit detection voltage threshold is less than a target background voltage of the one or more first pulse parameters.
Clause 15.The welding system of clause 13, wherein the control circuitry is further configured to, in response to determining that the short circuit event occurred by detecting that the measured voltage is less than the short circuit detection voltage threshold during the background phase, associate the short circuit event with one or more measured short circuit parameters and determine the one or more second pulse parameters based on the one or more measured short circuit parameters.
Clause 16.The welding system of clause 15, wherein:
   the one or more measured short circuit parameters comprise a measured short circuit duration;
   the one or more first pulse parameters comprise a first pulse width;
   the one or more second pulse parameters comprise a second pulse width; and
   the control circuitry is further configured to:
      in response to determining that the measured short circuit duration is greater than a target short circuit duration, calculate the second pulse width by increasing the first pulse width based on a difference between the measured short circuit duration and the target short circuit duration; and
      in response to determining that the measured short circuit duration is less than the target short circuit duration, calculate the second pulse width by decreasing the first pulse width based on the difference between the measured short circuit duration and the target short circuit duration.
Clause 17.The welding system of clause 15, wherein:
   the one or more measured short circuit parameters comprise a measured short circuit duration;
   the one or more first pulse parameters comprise a first target peak voltage;
   the one or more second pulse parameters comprise a second target peak voltage; and
   the control circuitry is further configured to:
      in response to determining that the measured short circuit duration is greater than a target short circuit duration, calculate the second target peak voltage by increasing the first target peak voltage based on a difference between the measured short circuit duration and the target short circuit duration; and
      in response to determining that the measured short circuit duration is less than the target short circuit duration, calculate the second target peak voltage by decreasing the first target peak voltage based on the difference between the measured short circuit duration and the target short circuit duration.
Clause 18.The welding system of clause 1, further comprising a power source configured to generate the input power and a power source sensor configured to measure a state of the power source and generate a power source sensor signal comprising a measured power source response, wherein the control circuitry is further configured to:
   monitor the power source sensor signal during the background phase to determine whether the short circuit event occurred by detecting a power source response short circuit indication; and
   in response to determining that the short circuit event occurred by detecting the power source response short circuit indication, associate the short circuit event with one or more power source response short circuit parameters and determine the one or more second pulse parameters based on the one or more power source response short circuit parameters.
Clause 19.The welding system of clause 1, further comprising an audio sensor configured to measure audio feedback of the welding system and generate an audio sensor signal comprising a detected audio, wherein the control circuitry is further configured to:
   monitor the audio sensor signal during the background phase to determine whether the short circuit event occurred by detecting an audio short circuit indication; and
   in response to determining that the short circuit event occurred by detecting the audio short circuit indication, associate the short circuit event with one or more audio short circuit parameters and determine the one or more second pulse parameters based on the one or more audio short circuit parameters.
Clause 20.The welding system of clause 1, further comprising a spectrometer configured to measure a spectrographic emission of a welding arc of the weld circuit and generate a spectrometer signal comprising a measured spectrographic emission, wherein the control circuitry is further configured to:
   monitor the spectrometer signal during the background phase to determine whether the short circuit event occurred by detecting a spectrographic short circuit indication; and
   in response to determining that the short circuit event occurred by detecting the spectrographic short circuit indication, associate the short circuit event with one or more spectrographic short circuit parameters and determine the one or more second pulse parameters based on the one or more spectrographic short circuit parameters.
Clause 21.A welding system comprising:
   power conversion circuitry configured to convert input power to welding power and to output the welding power to a weld circuit;
   a voltage sensor configured to measure a voltage of the weld circuit and generate a voltage sensor signal comprising a measured voltage; and
   control circuitry configured to:
      control the power conversion circuitry to output the welding power according to one or more first welding parameters;
      monitor the voltage sensor signal while the power conversion circuitry outputs the welding power according to the one or more first welding parameters to determine whether a short circuit event occurred in the weld circuit by detecting that the measured voltage is greater than an anomalous cathode event voltage threshold;
      in response to determining that the short circuit event occurred, determine one or more second welding parameters based on the one or more first welding parameters and one or more short circuit parameters of the short circuit event; and
      control the power conversion circuitry to output the welding power according to the one or more second welding parameters.
Clause 22.The welding system of clause 21, wherein the power conversion circuitry is configured to output the welding power according to at least one of:
   a gas-metal arc welding (GMAW) or metal inert gas welding (MIG) operation;
   a pulsed gas-metal arc welding (GMAW-P) or pulsed metal inert gas (pulse MIG) welding operation;
   a current-controlled welding operation;
   a voltage-controlled welding operation;
   a power-controlled welding operation;
   a resistance-controlled welding operation;
   an enthalpy-controlled welding operation;
   a tungsten inert gas welding (TIG) or gas tungsten arc welding (GTAW) operation;
   a flux cored arc welding (FCAW) operation;
   a shielded metal arc welding (SMAW) or stick welding operation;
   a plasma cutting operation;
   a plasma welding operation;
   a spray welding operation;
   a short circuit transfer welding operation;
   a pulse welding operation; or
   a pulsed spray welding operation.
Clause 23.The welding system of clause 21, wherein the anomalous cathode event voltage threshold is greater than a target voltage of the one or more first welding parameters.
Clause 24.The welding system of clause 21, wherein at least one of the one or more second welding parameters are configured to maintain an arc length of a welding arc of the weld circuit based on the one or more short circuit parameters and on a target arc length.
Clause 25.The welding system of clause 21, wherein:
   the control circuitry is further configured to compare the one or more short circuit parameters to one or more target short circuit parameters to determine one or more short circuit parameter target differences; and
   the determining of the one or more second welding parameters is based on the one or more first welding parameters and the one or more short circuit parameter target differences.
Clause 26.The welding system of clause 25, wherein the determining of the one or more second welding parameters further comprises:
   in response to determining that a magnitude of at least one of the one or more short circuit parameter target differences is greater than a short circuit parameter target difference magnitude threshold, modifying at least one of the one or more first welding parameters based on the magnitude of the at least one of the one or more short circuit parameter target differences; and
   in response to determining that the magnitude of at least one of the one or more short circuit parameter target differences is not greater than the short circuit parameter target difference magnitude threshold, maintaining the one or more first welding parameters as the one or more second welding parameters.
Clause 27.The welding system of clause 21, wherein:
   the one or more first welding parameters comprise at least one of a first ramp up rate, a first wire feed speed, a first ramp down rate, a first target voltage, a first target current, a first target power, a first target resistance, a first target enthalpy, a first duration of one or more waveform phases, a first duration of a portion of a waveform, or a first waveform frequency; and
   the one or more second welding parameters comprise at least one of a second ramp up rate, a second ramp down rate, a second wire feed speed, a second target voltage, a second target current, a second target power, a second target resistance, a second target enthalpy, a second duration of the one or more waveform phases, a second duration of the portion of the waveform, or a second waveform frequency.
Clause 28.The welding system of clause 21, wherein the one or more short circuit parameters comprise at least one of a measured short circuit duration, a predetermined short circuit duration, a measured short circuit voltage, a measured average short circuit voltage, a predetermined short circuit voltage, a measured short circuit current, a measured average short circuit current, or a predetermined short circuit current.
Clause 29.The welding system of clause 21, wherein the control circuitry is further configured to, in response to determining that the short circuit event occurred by detecting that the measured voltage is greater than the anomalous cathode event voltage threshold, associate the short circuit event with one or more predetermined short circuit parameters associated with an anomalous cathode event and determine the one or more second welding parameters based on the one or more predetermined short circuit parameters.
Clause 30.The welding system of clause 29, wherein:
   the one or more predetermined short circuit parameters comprise a predetermined short circuit duration;
   the one or more first welding parameters comprise a first target voltage;
   the one or more second welding parameters comprise a second target voltage; and
   the control circuitry is further configured to:
      in response to determining that the predetermined short circuit duration is greater than a target short circuit duration, determine the second target voltage by increasing the first target voltage based on a difference between the predetermined short circuit duration and the target short circuit duration; and
      in response to determining that the predetermined short circuit duration is less than the target short circuit duration, determine the second target voltage by decreasing the first target voltage based on the difference between the predetermined short circuit duration and the target short circuit duration.
Clause 31.The welding system of clause 29, wherein:
   the one or more predetermined short circuit parameters comprise a predetermined short circuit duration; and
   the control circuitry is further configured to determine the predetermined short circuit duration based on a sampling rate of the voltage sensor.
Clause 32.The welding system of clause 21, wherein the control circuitry is further configured to monitor the voltage sensor signal while the power conversion circuitry outputs the welding power according to the one or more first welding parameters to determine whether the short circuit event occurred in the weld circuit by detecting that the measured voltage is less than a short circuit detection voltage threshold.
Clause 33.The welding system of clause 32, wherein the short circuit detection voltage threshold is less than a target voltage of the one or more first welding parameters.
Clause 34.The welding system of clause 32, wherein the control circuitry is further configured to, in response to determining that the short circuit event occurred by detecting that the measured voltage is less than the short circuit detection voltage threshold, associate the short circuit event with one or more measured short circuit parameters and determine the one or more second welding parameters based on the one or more measured short circuit parameters.
Clause 35.The welding system of clause 34, wherein:
   the one or more measured short circuit parameters comprise a measured short circuit duration;
   the one or more first welding parameters comprise a first target voltage;
   the one or more second welding parameters comprise a second target voltage; and
   the control circuitry is further configured to:
      in response to determining that the measured short circuit duration is greater than a target short circuit duration, calculate the second target voltage by increasing the first target voltage based on a difference between the measured short circuit duration and the target short circuit duration; and
      in response to determining that the measured short circuit duration is less than the target short circuit duration, calculate the second target voltage by decreasing the first target voltage based on the difference between the measured short circuit duration and the target short circuit duration.
Clause 36.The welding system of clause 21, wherein:
   the short circuit event is a first short circuit event;
   the one or more short circuit parameters are one or more first short circuit parameters; and
   the control circuitry is further configured to:
      monitor the voltage sensor signal while the power conversion circuitry outputs the welding power according to the one or more second welding parameters to determine whether a second short circuit event occurred in the weld circuit by detecting that the measured voltage is greater than the anomalous cathode event voltage threshold;
      in response to determining that the second short circuit event occurred, determine one or more third welding parameters based on the one or more second welding parameters and one or more second short circuit parameters of the second short circuit event; and
      control the power conversion circuitry to output the welding power according to the one or more third welding parameters.
Clause 37.The welding system of clause 21, wherein the one or more first welding parameters comprise one or more first pulse parameters of one or more first pulse cycles.
Clause 38.The welding system of clause 21, further comprising a power source configured to generate the input power and a power source sensor configured to measure a state of the power source and generate a power source sensor signal comprising a measured power source response, wherein the control circuitry is further configured to:
   monitor the power source sensor signal to determine whether the short circuit event occurred by detecting a power source response short circuit indication; and
   in response to determining that the short circuit event occurred by detecting the power source response short circuit indication, associate the short circuit event with one or more power source response short circuit parameters and determine the one or more second welding parameters based on the one or more power source response short circuit parameters.
Clause 39.The welding system of clause 21, further comprising an audio sensor configured to measure audio feedback of the welding system and generate an audio sensor signal comprising a detected audio, wherein the control circuitry is further configured to:
   monitor the audio sensor signal to determine whether the short circuit event occurred by detecting an audio short circuit indication; and
   in response to determining that the short circuit event occurred by detecting the audio short circuit indication, associate the short circuit event with one or more audio short circuit parameters and determine the one or more second welding parameters based on the one or more audio short circuit parameters.
Clause 40.The welding system of clause 21, further comprising a spectrometer configured to measure a spectrographic emission of a welding arc of the weld circuit and generate a spectrometer signal comprising a measured spectrographic emission, wherein the control circuitry is further configured to:
   monitor the spectrometer signal to determine whether the short circuit event occurred by detecting a spectrographic short circuit indication; and
   in response to determining that the short circuit event occurred by detecting the spectrographic short circuit indication, associate the short circuit event with one or more spectrographic short circuit parameters and determine the one or more second welding parameters based on the one or more spectrographic short circuit parameters.

## Claims

1. A welding system comprising:
power conversion circuitry configured to convert input power to welding power and to output the welding power to a weld circuit;
a voltage sensor configured to measure a voltage of the weld circuit and generate a voltage sensor signal comprising a measured voltage; and
control circuitry configured to:
control the power conversion circuitry to output the welding power according to one or more first pulse cycles having one or more first pulse parameters;
monitor the voltage sensor signal during a background phase of the one or more first pulse cycles to determine whether a short circuit event occurred in the weld circuit by detecting that the measured voltage is greater than an anomalous cathode event voltage threshold;
in response to determining that the short circuit event occurred, determine one or more second pulse parameters based on the one or more first pulse parameters and one or more short circuit parameters of the short circuit event; and
control the power conversion circuitry to output the welding power according to one or more second pulse cycles having the one or more second pulse parameters.

2. The welding system of claim 1, wherein the anomalous cathode event voltage threshold is greater than a target background voltage of the one or more first pulse parameters, or
wherein at least one of the one or more second pulse parameters are configured to maintain an arc length of a welding arc of the weld circuit based on the one or more short circuit parameters and on a target arc length, or
wherein:
the control circuitry is further configured to compare the one or more short circuit parameters to one or more target short circuit parameters to determine one or more short circuit parameter target differences; and
the determining of the one or more second pulse parameters is based on the one or more first pulse parameters and the one or more short circuit parameter target differences, and optionally wherein the determining of the one or more second pulse parameters further comprises:
in response to determining that a magnitude of at least one of the one or more short circuit parameter target differences is greater than a short circuit parameter target difference magnitude threshold, modifying at least one of the one or more first pulse parameters based on the magnitude of the at least one of the one or more short circuit parameter target differences; and
in response to determining that the magnitude of at least one of the one or more short circuit parameter target differences is not greater than the short circuit parameter target difference magnitude threshold, maintaining the one or more first pulse parameters as the one or more second pulse parameters.

3. The welding system of claim 1, wherein:
the one or more first pulse parameters comprise a first pulse width; and
the one or more second pulse parameters comprise a second pulse width, or
wherein:
the one or more first pulse parameters comprise at least one of a first pulse width, a first pulse frequency, a first wire feed speed, a first ramp up rate, a first ramp down rate, a first target peak voltage, a first target peak current, a first target background voltage, a first target background current, a first target power, a first target resistance, or a first target enthalpy; and
the one or more second pulse parameters comprise at least one of a second pulse width, a second pulse frequency, a second wire feed speed, a second ramp up rate, a second ramp down rate, a second target peak voltage, a second target peak current, a second target background voltage, a second target background current, a second target power, a second target resistance, or a second target enthalpy, or wherein the one or more short circuit parameters comprise at least one of a measured short circuit duration, a predetermined short circuit duration, a measured short circuit voltage, a measured average short circuit voltage, a predetermined short circuit voltage, a measured short circuit current, a measured average short circuit current, or a predetermined short circuit current, or wherein the control circuitry is further configured to, in response to determining that the short circuit event occurred by detecting that the measured voltage is greater than the anomalous cathode event voltage threshold during the background phase, associate the short circuit event with one or more predetermined short circuit parameters associated with an anomalous cathode event and determine the one or more second pulse parameters based on the one or more predetermined short circuit parameters, and optionally,wherein:
the one or more predetermined short circuit parameters comprise a predetermined short circuit duration;
the one or more first pulse parameters comprise a first pulse width;
the one or more second pulse parameters comprise a second pulse width; and
the control circuitry is further configured to, in response to determining that the predetermined short circuit duration is greater than a target short circuit duration, determine the second pulse width by increasing the first pulse width based on a difference between the predetermined short circuit duration and the target short circuit duration, and optionally wherein:
the one or more predetermined short circuit parameters comprise a predetermined short circuit duration;
the one or more first pulse parameters comprise a first pulse width;
the one or more second pulse parameters comprise a second pulse width; and
the control circuitry is further configured to, in response to determining that the predetermined short circuit duration is less than a target short circuit duration, determine the second pulse width by decreasing the first pulse width based on a difference between the predetermined short circuit duration and the target short circuit duration, and optionally wherein the control circuitry is further configured to determine the predetermined short circuit duration based on a sampling rate of the voltage sensor.

4. The welding system of claim 1, wherein the control circuitry is further configured to monitor the voltage sensor signal during the background phase to determine whether the short circuit event occurred in the weld circuit by detecting that the measured voltage is less than a short circuit detection voltage threshold, and optionally wherein the short circuit detection voltage threshold is less than a target background voltage of the one or more first pulse parameters, and optionally wherein the control circuitry is further configured to, in response to determining that the short circuit event occurred by detecting that the measured voltage is less than the short circuit detection voltage threshold during the background phase, associate the short circuit event with one or more measured short circuit parameters and determine the one or more second pulse parameters based on the one or more measured short circuit parameters, and optionally wherein:
the one or more measured short circuit parameters comprise a measured short circuit duration;
the one or more first pulse parameters comprise a first pulse width;
the one or more second pulse parameters comprise a second pulse width; and
the control circuitry is further configured to:
in response to determining that the measured short circuit duration is greater than a target short circuit duration, calculate the second pulse width by increasing the first pulse width based on a difference between the measured short circuit duration and the target short circuit duration; and
in response to determining that the measured short circuit duration is less than the target short circuit duration, calculate the second pulse width by decreasing the first pulse width based on the difference between the measured short circuit duration and the target short circuit duration, and optionally wherein:
the one or more measured short circuit parameters comprise a measured short circuit duration;
the one or more first pulse parameters comprise a first target peak voltage;
the one or more second pulse parameters comprise a second target peak voltage; and
the control circuitry is further configured to:
in response to determining that the measured short circuit duration is greater than a target short circuit duration, calculate the second target peak voltage by increasing the first target peak voltage based on a difference between the measured short circuit duration and the target short circuit duration; and
in response to determining that the measured short circuit duration is less than the target short circuit duration, calculate the second target peak voltage by decreasing the first target peak voltage based on the difference between the measured short circuit duration and the target short circuit duration.

5. The welding system of claim 1, further comprising a power source configured to generate the input power and a power source sensor configured to measure a state of the power source and generate a power source sensor signal comprising a measured power source response, wherein the control circuitry is further configured to:
monitor the power source sensor signal during the background phase to determine whether the short circuit event occurred by detecting a power source response short circuit indication; and
in response to determining that the short circuit event occurred by detecting the power source response short circuit indication, associate the short circuit event with one or more power source response short circuit parameters and determine the one or more second pulse parameters based on the one or more power source response short circuit parameters.

6. The welding system of claim 1, further comprising an audio sensor configured to measure audio feedback of the welding system and generate an audio sensor signal comprising a detected audio, wherein the control circuitry is further configured to:
monitor the audio sensor signal during the background phase to determine whether the short circuit event occurred by detecting an audio short circuit indication; and
in response to determining that the short circuit event occurred by detecting the audio short circuit indication, associate the short circuit event with one or more audio short circuit parameters and determine the one or more second pulse parameters based on the one or more audio short circuit parameters.

7. The welding system of claim 1, further comprising a spectrometer configured to measure a spectrographic emission of a welding arc of the weld circuit and generate a spectrometer signal comprising a measured spectrographic emission, wherein the control circuitry is further configured to:
monitor the spectrometer signal during the background phase to determine whether the short circuit event occurred by detecting a spectrographic short circuit indication; and
in response to determining that the short circuit event occurred by detecting the spectrographic short circuit indication, associate the short circuit event with one or more spectrographic short circuit parameters and determine the one or more second pulse parameters based on the one or more spectrographic short circuit parameters.

8. A welding system comprising:
power conversion circuitry configured to convert input power to welding power and to output the welding power to a weld circuit;
a voltage sensor configured to measure a voltage of the weld circuit and generate a voltage sensor signal comprising a measured voltage; and
control circuitry configured to:
control the power conversion circuitry to output the welding power according to one or more first welding parameters;
monitor the voltage sensor signal while the power conversion circuitry outputs the welding power according to the one or more first welding parameters to determine whether a short circuit event occurred in the weld circuit by detecting that the measured voltage is greater than an anomalous cathode event voltage threshold;
in response to determining that the short circuit event occurred, determine one or more second welding parameters based on the one or more first welding parameters and one or more short circuit parameters of the short circuit event; and
control the power conversion circuitry to output the welding power according to the one or more second welding parameters.

9. The welding system of claim 8, wherein the power conversion circuitry is configured to output the welding power according to at least one of:
a gas-metal arc welding (GMAW) or metal inert gas welding (MIG) operation;
a pulsed gas-metal arc welding (GMAW-P) or pulsed metal inert gas (pulse MIG) welding operation;
a current-controlled welding operation;
a voltage-controlled welding operation;
a power-controlled welding operation;
a resistance-controlled welding operation;
an enthalpy-controlled welding operation;
a tungsten inert gas welding (TIG) or gas tungsten arc welding (GTAW) operation;
a flux cored arc welding (FCAW) operation;
a shielded metal arc welding (SMAW) or stick welding operation;
a plasma cutting operation;
a plasma welding operation;
a spray welding operation;
a short circuit transfer welding operation;
a pulse welding operation; or
a pulsed spray welding operation or
wherein the anomalous cathode event voltage threshold is greater than a target voltage of the one or more first welding parameters, or wherein at least one of the one or more second welding parameters are configured to maintain an arc length of a welding arc of the weld circuit based on the one or more short circuit parameters and on a target arc length.

10. The welding system of claim 8, wherein:
the control circuitry is further configured to compare the one or more short circuit parameters to one or more target short circuit parameters to determine one or more short circuit parameter target differences; and
the determining of the one or more second welding parameters is based on the one or more first welding parameters and the one or more short circuit parameter target differences, and optionally wherein the determining of the one or more second welding parameters further comprises:
in response to determining that a magnitude of at least one of the one or more short circuit parameter target differences is greater than a short circuit parameter target difference magnitude threshold, modifying at least one of the one or more first welding parameters based on the magnitude of the at least one of the one or more short circuit parameter target differences; and
in response to determining that the magnitude of at least one of the one or more short circuit parameter target differences is not greater than the short circuit parameter target difference magnitude threshold, maintaining the one or more first welding parameters as the one or more second welding parameters.

11. The welding system of claim 8, wherein:
the one or more first welding parameters comprise at least one of a first ramp up rate, a first wire feed speed, a first ramp down rate, a first target voltage, a first target current, a first target power, a first target resistance, a first target enthalpy, a first duration of one or more waveform phases, a first duration of a portion of a waveform, or a first waveform frequency; and
the one or more second welding parameters comprise at least one of a second ramp up rate, a second ramp down rate, a second wire feed speed, a second target voltage, a second target current, a second target power, a second target resistance, a second target enthalpy, a second duration of the one or more waveform phases, a second duration of the portion of the waveform, or a second waveform frequency, or wherein the one or more short circuit parameters comprise at least one of a measured short circuit duration, a predetermined short circuit duration, a measured short circuit voltage, a measured average short circuit voltage, a predetermined short circuit voltage, a measured short circuit current, a measured average short circuit current, or a predetermined short circuit current, or wherein the control circuitry is further configured to, in response to determining that the short circuit event occurred by detecting that the measured voltage is greater than the anomalous cathode event voltage threshold, associate the short circuit event with one or more predetermined short circuit parameters associated with an anomalous cathode event and determine the one or more second welding parameters based on the one or more predetermined short circuit parameters, and optionally wherein:
the one or more predetermined short circuit parameters comprise a predetermined short circuit duration;
the one or more first welding parameters comprise a first target voltage;
the one or more second welding parameters comprise a second target voltage; and
the control circuitry is further configured to:
in response to determining that the predetermined short circuit duration is greater than a target short circuit duration, determine the second target voltage by increasing the first target voltage based on a difference between the predetermined short circuit duration and the target short circuit duration; and
in response to determining that the predetermined short circuit duration is less than the target short circuit duration, determine the second target voltage by decreasing the first target voltage based on the difference between the predetermined short circuit duration and the target short circuit duration, and optionally wherein:
the one or more predetermined short circuit parameters comprise a predetermined short circuit duration; and
the control circuitry is further configured to determine the predetermined short circuit duration based on a sampling rate of the voltage sensor.

12. The welding system of claim 8, wherein the control circuitry is further configured to monitor the voltage sensor signal while the power conversion circuitry outputs the welding power according to the one or more first welding parameters to determine whether the short circuit event occurred in the weld circuit by detecting that the measured voltage is less than a short circuit detection voltage threshold.

13. The welding system of claim 12, wherein the short circuit detection voltage threshold is less than a target voltage of the one or more first welding parameters or
wherein the control circuitry is further configured to, in response to determining that the short circuit event occurred by detecting that the measured voltage is less than the short circuit detection voltage threshold, associate the short circuit event with one or more measured short circuit parameters and determine the one or more second welding parameters based on the one or more measured short circuit parameters, and optionally wherein:
the one or more measured short circuit parameters comprise a measured short circuit duration;
the one or more first welding parameters comprise a first target voltage;
the one or more second welding parameters comprise a second target voltage; and
the control circuitry is further configured to:
in response to determining that the measured short circuit duration is greater than a target short circuit duration, calculate the second target voltage by increasing the first target voltage based on a difference between the measured short circuit duration and the target short circuit duration; and
in response to determining that the measured short circuit duration is less than the target short circuit duration, calculate the second target voltage by decreasing the first target voltage based on the difference between the measured short circuit duration and the target short circuit duration.

14. The welding system of claim 8, wherein:
the short circuit event is a first short circuit event;
the one or more short circuit parameters are one or more first short circuit parameters; and
the control circuitry is further configured to:
monitor the voltage sensor signal while the power conversion circuitry outputs the welding power according to the one or more second welding parameters to determine whether a second short circuit event occurred in the weld circuit by detecting that the measured voltage is greater than the anomalous cathode event voltage threshold;
in response to determining that the second short circuit event occurred, determine one or more third welding parameters based on the one or more second welding parameters and one or more second short circuit parameters of the second short circuit event; and
control the power conversion circuitry to output the welding power according to the one or more third welding parameters.

15. The welding system of claim 8, wherein the one or more first welding parameters comprise one or more first pulse parameters of one or more first pulse cycles, or wherein
the welding system further comprises a power source configured to generate the input power and a power source sensor configured to measure a state of the power source and generate a power source sensor signal comprising a measured power source response, wherein the control circuitry is further configured to:
monitor the power source sensor signal to determine whether the short circuit event occurred by detecting a power source response short circuit indication; and
in response to determining that the short circuit event occurred by detecting the power source response short circuit indication, associate the short circuit event with one or more power source response short circuit parameters and determine the one or more second welding parameters based on the one or more power source response short circuit parameters, or wherein the welding system further comprises an audio sensor configured to measure audio feedback of the welding system and generate an audio sensor signal comprising a detected audio, wherein the control circuitry is further configured to:
monitor the audio sensor signal to determine whether the short circuit event occurred by detecting an audio short circuit indication; and
in response to determining that the short circuit event occurred by detecting the audio short circuit indication, associate the short circuit event with one or more audio short circuit parameters and determine the one or more second welding parameters based on the one or more audio short circuit parameters, or wherein
the welding system further comprises a spectrometer configured to measure a spectrographic emission of a welding arc of the weld circuit and generate a spectrometer signal comprising a measured spectrographic emission, wherein the control circuitry is further configured to:
monitor the spectrometer signal to determine whether the short circuit event occurred by detecting a spectrographic short circuit indication; and
in response to determining that the short circuit event occurred by detecting the spectrographic short circuit indication, associate the short circuit event with one or more spectrographic short circuit parameters and determine the one or more second welding parameters based on the one or more spectrographic short circuit parameters.
